# EUROPEAN PATENT APPLICATION

(11) **EP 4 733 885 A1**
(43) Date of publication of application: **29.04.2026**
(21) Application number: 24877367.3
(22) Date of filing: 25.07.2024
(51) Int. Cl.: G06F 1/16

(54) **HINGE ASSEMBLY AND ELECTRONIC DEVICE COMPRISING SAME**

(30) Priority: 13.10.2023 KR 20230136475; 20.11.2023 KR 20230160337
(71) Applicant: Samsung Electronics Co., Ltd., Suwon-si, Gyeonggi-do 16677 (KR)
(72) Inventor: KIM, Gyeongtae, Suwon-si Gyeonggi-do 16677 (KR); SEOK, Sangyoup, Suwon-si Gyeonggi-do 16677 (KR); SON, Kwonho, Suwon-si Gyeonggi-do 16677 (KR); YANG, Soonwoong, Suwon-si Gyeonggi-do 16677 (KR); LEE, Seunghoon, Suwon-si Gyeonggi-do 16677 (KR); JUNG, Minsu, Suwon-si Gyeonggi-do 16677 (KR)
(74) Representative: HGF
(86) International application number: PCT/KR2024/010864
(87) International publication number: WO 2025/079828

(57) **Abstract**

In an embodiment, an electronic device may comprise: a display; a first housing; a second housing; a hinge housing; and a hinge assembly. The hinge assembly may comprise: a hinge bracket; a shaft connected to the hinge bracket so as to be rotatable about a first axis; a rotation protrusion member connected to one end of the shaft so as to rotate integrally with the shaft, and including a protrusion protruding parallel to the first axis at a position eccentric from the first axis; and a sliding member positioned to be slidable with respect to the hinge housing in a first direction perpendicular to the first axis. During the transition of the electronic device from an unfolded state to a folded state, the sliding member may be slid in the first direction by the rotational movement of the protrusion about the first axis. When the electronic device is in the folded state, at least a portion of the sliding member may protrude to the outside of the hinge housing and come into contact with the first housing or the second housing.

## Description

### BACKGROUND

### 1. Field

Various embodiments of the disclosure relates to a hinge assembly and an electronic device including the hinge assembly.

### 2. Description of the Related Art

Recently, with the development of display-related technologies, electronic devices with flexible displays are being developed. A flexible display may be used in the form of a flat surface, and may also be deformed to be used in a specific shape. For example, an electronic device with a flexible display may be implemented in a foldable form to be folded or unfolded about at least one folding axis.

### SUMMARY

In an embodiment, an electronic device may include a display including a first area, a second area, and a folding area between the first area and the second area, a first housing configured to support the first area and including a first seating portion, a second housing configured to support the second area and including a second seating portion, a hinge housing which is positioned on the first seating portion and the second seating portion in an unfolded state of the electronic device, and at least a portion of which is exposed to outside of the electronic device in a folded state of the electronic device, and a hinge assembly positioned inside the hinge housing and connecting the first housing and the second housing. The hinge assembly may include a hinge bracket, a shaft rotatably connected to the hinge bracket about a first axis, a rotation protrusion member connected to one end portion of the shaft to rotate integrally with the shaft, and including a protrusion protruding parallel to the first axis at a position eccentric from the first axis, and a sliding member positioned to be slidable with respect to the hinge housing in a first direction perpendicular to the first axis. In the unfolded state of the electronic device, the sliding member may be positioned inside the hinge housing. In a process in which the state of the electronic device changes from the unfolded state to the folded state, the sliding member may slide in the first direction by a rotational movement of the protrusion about the first axis. In the folded state of the electronic device, at least a portion of the sliding member may protrude outside the hinge housing to be in contact with the first housing or the second housing.

In an embodiment, a hinge assembly applied to an electronic device including a first housing, a second housing, and a hinge housing may include a hinge bracket, a shaft rotatably connected to the hinge bracket about a first axis, a rotation protrusion member connected to one end portion of the shaft to rotate integrally with the shaft, and including a protrusion protruding parallel to the first axis at a position eccentric from the first axis, and a sliding member positioned to be slidable with respect to the hinge housing in a first direction perpendicular to the first axis. In the unfolded state of the electronic device, the sliding member may be positioned inside the hinge housing. In a process in which the state of the electronic device changes from the unfolded state to the folded state, the sliding member may slide in the first direction by a rotational movement of the protrusion about the first axis. In the folded state of the electronic device, at least a portion of the sliding member may protrude outside the hinge housing to be in contact with the first housing or the second housing.

In an embodiment, an electronic device may include a display including a first area, a second area, and a folding area between the first area and the second area, a first housing configured to support the first area and including a first seating portion, a second housing configured to support the second area and including a second seating portion, a hinge housing which is positioned on the first seating portion and the second seating portion in an unfolded state of the electronic device, and at least a portion of which is exposed to outside of the electronic device in a folded state of the electronic device, and a hinge assembly positioned inside the hinge housing and connecting the first housing and the second housing. The hinge assembly may include a hinge bracket, a shaft rotatably connected to the hinge bracket about a first axis, a rotation protrusion member connected to one end portion of the shaft to rotate integrally with the shaft, and including a protrusion protruding parallel to the first axis at a position eccentric from the first axis, a sliding member positioned to be slidable with respect to the hinge housing in a first direction perpendicular to the first axis and including a first opening, into which the protrusion is inserted, an elastic member configured to restore a position of the sliding member in a process of unfolding the electronic device in the folded state, and a cover member covering the hinge assembly. In the unfolded state of the electronic device, the sliding member may be positioned inside the hinge housing. In the folded state of the electronic device, the sliding member may slide in the first direction. In the folded state of the electronic device, at least a portion of the sliding member may protrude outside the hinge housing to be in contact with the first housing or the second housing. The first opening may have a curved shape having the first axis as a center. A length of a path formed by the first opening may be shorter than a length of a path, along which the protrusion moves until the electronic device is folded in the unfolded state. The sliding member may be guided to slide in the first direction by the cover member and the hinge housing.

In an embodiment, the sliding member of the hinge assembly may reduce the phenomenon of the hinge housing and the first housing or the hinge housing or the second housing coming into contact with each other and causing friction during unfolding or folding the electronic device.

The effects of a hinge assembly and an electronic device including the same according to various embodiments may not be limited to the above-mentioned effects, and other unmentioned effects may be clearly understood from the following description by one of ordinary skill in the art.

### BRIEF DESCRIPTION OF DRAWINGS

The foregoing and other aspects, features, and advantages of certain embodiments in the disclosure will become apparent from the following detailed description with reference to the accompanying drawings.
FIG. 1 is a block diagram illustrating an electronic device in a network environment according to various embodiments.
FIG. 2A is a view illustrating an electronic device in an unfolded state, according to various embodiments.
FIG. 2B is a view illustrating an electronic device in a folded state, according to various embodiments.
FIG. 3 is a plan view of inside of an electronic device illustrating a state in which a hinge assembly is disposed in the electronic device according to an embodiment.
FIG. 4 is a perspective view illustrating an unfolded state of a hinge assembly according to an embodiment.
FIG. 5 is a front view illustrating an unfolded state of a hinge assembly according to an embodiment.
FIG. 6 is a rear view illustrating an unfolded state of a hinge assembly according to an embodiment.
FIG. 7 is a perspective view illustrating a hinge bracket according to an embodiment.
FIG. 8 is a perspective view illustrating a first arm member according to an embodiment.
FIG. 9 is a front view illustrating a cam member according to an embodiment.
FIG. 10 is a perspective view illustrating a first wing member according to an embodiment.
FIG. 11 is a perspective view illustrating a first rotation bracket according to an embodiment.
FIG. 12 is a partially exploded perspective view of a hinge assembly according to an embodiment.
FIG. 13 is an enlarged view of a portion B of FIG. 3.
FIG. 14 is a cross-sectional view taken along line I-I of FIG. 13.
FIG. 15 is a cross-sectional view taken along line II-II of FIG. 13.
FIG. 16 is a cross-sectional view taken along line III-III of FIG. 13.
FIG. 17 is a cross-sectional view illustrating a partially folded state of an electronic device according to an embodiment.
FIG. 18 is a cross-sectional view illustrating a fully folded state of an electronic device according to an embodiment.
FIG. 19 is a side view illustrating a hinge assembly according to an embodiment.
FIG. 20A is a partial front view illustrating a hinge assembly according to an embodiment.
FIG. 20B is a side view illustrating an unfolded state of a hinge assembly according to an embodiment.
FIG. 20C is a side view illustrating a folded state of a hinge assembly according to an embodiment.
FIG. 20D is a cross-sectional view of an unfolded state of an electronic device according to an embodiment.
FIG. 20E is a cross-sectional view of a folded state of an electronic device according to an embodiment.

### DETAILED DESCRIPTION

Hereinafter, embodiments will be described in detail with reference to the accompanying drawings. When describing the embodiments with reference to the accompanying drawings, like reference numerals refer to like elements and a repeated description related thereto will be omitted.

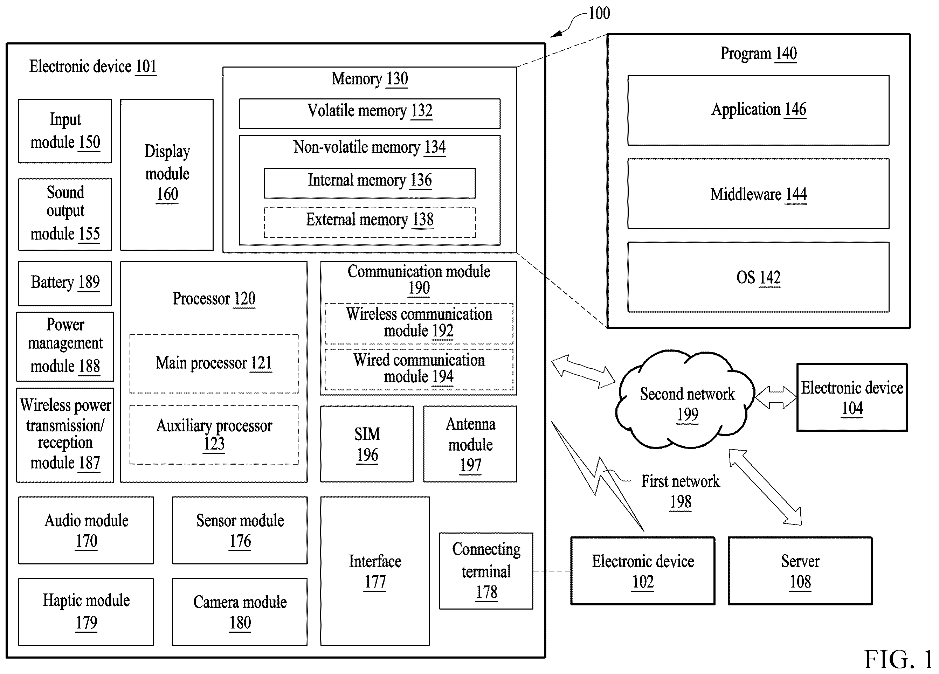

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or communicate with an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, a memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one (e.g., the connecting terminal 178) of the above components may be omitted from the electronic device 101, or one or more other components may be added in the electronic device 101. In some embodiments, some of the components (e.g., the sensor module 176, the camera module 180, or the antenna module 197) may be integrated as a single component (e.g., the display module 160).

The processor 120 may execute, for example, software (e.g., a program 140) to control at least one other component (e.g., a hardware or software component) of the electronic device 101 connected to the processor 120, and may perform various data processing or computation. According to an embodiment, as at least a portion of data processing or computation, the processor 120 may store a command or data received from another component (e.g., the sensor module 176 or the communication module 190) in a volatile memory 132, process the command or the data stored in the volatile memory 132, and store resulting data in a non-volatile memory 134. According to an embodiment, the processor 120 may include a main processor 121 (e.g., a central processing unit (CPU) or an application processor (AP)) or an auxiliary processor 123 (e.g., a graphics processing unit (GPU), a neural processing unit (NPU), an image signal processor (ISP), a sensor hub processor, or a communication processor (CP)) that is operable independently of, or in conjunction with the main processor 121. For example, in an embodiment where the electronic device 101 includes the main processor 121 and the auxiliary processor 123, the auxiliary processor 123 may be adapted to consume less power than the main processor 121 or to be specific to a specified function. The auxiliary processor 123 may be implemented separately from the main processor 121 or as a part of the main processor 121.

The auxiliary processor 123 may control at least some of functions or states related to at least one (e.g., the display module 160, the sensor module 176, or the communication module 190) of the components of the electronic device 101, instead of the main processor 121 while the main processor 121 is in an inactive (e.g., sleep) state or along with the main processor 121 while the main processor 121 is in an active state (e.g., executing an application). According to an embodiment, the auxiliary processor 123 (e.g., an ISP or a CP) may be implemented as a portion of another component (e.g., the camera module 180 or the communication module 190) that is functionally related to the auxiliary processor 123. According to an embodiment, the auxiliary processor 123 (e.g., an NPU) may include a hardware structure specified for artificial intelligence (AI) model processing. An AI model may be generated by machine learning. Such learning may be performed by, for example, the electronic device 101 in which artificial intelligence is performed, or performed via a separate server (e.g., the server 108). Learning algorithms may include, but are not limited to, for example, supervised learning, unsupervised learning, semi-supervised learning, or reinforcement learning. The AI model may include a plurality of artificial neural network layers. An artificial neural network may include, for example, a deep neural network (DNN), a convolutional neural network (CNN), a recurrent neural network (RNN), a restricted Boltzmann machine (RBM), a deep belief network (DBN), and a bidirectional recurrent deep neural network (BRDNN), a deep Q-network, or a combination of two or more thereof, but is not limited thereto. The AI model may additionally or alternatively include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored as software in the memory 130, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output a sound signal to the outside of the electronic device 101. The sound output module 155 may include, for example, a speaker or a receiver. The speaker may be used for general purposes, such as playing multimedia or playing record. The receiver may be used to receive an incoming call. According to an embodiment, the receiver may be implemented separately from the speaker or as a part of the speaker.

The display module 160 may visually provide information to the outside (e.g., a user) of the electronic device 101. The display module 160 may include, for example, a display, a hologram device, or a projector and control circuitry to control a corresponding one of the display, the hologram device, or the projector. According to an embodiment, the display module 160 may include a touch sensor adapted to sense a touch, or a pressure sensor adapted to measure an intensity of a force incurred by the touch.

The audio module 170 may convert a sound into an electric signal or vice versa. According to an embodiment, the audio module 170 may obtain the sound via the input module 150 or output the sound via the sound output module 155 or an external electronic device (e.g., an electronic device 102 such as a speaker or a headphone) directly or wirelessly connected to the electronic device 101.

The sensor module 176 may detect an operational state (e.g., power or temperature) of the electronic device 101 or an environmental state (e.g., a state of a user) external to the electronic device 101, and generate an electric signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., by wire) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may be physically connected to an external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electric signal into a mechanical stimulus (e.g., a vibration or a movement) or an electrical stimulus which may be recognized by a user via his or her tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, ISPs, or flashes.

The power management module 188 may manage power supplied to the electronic device 101. According to an embodiment, the power management module 188 may be implemented as, for example, at least a part of a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently of the processor 120 (e.g., an AP) and that support a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device 104 via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., a LAN or a wide area network (WAN))). These various types of communication modules may be implemented as a single component (e.g., a single chip), or may be implemented as multi components (e.g., multiple chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., a mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), an array antenna, analog beam-forming, or a large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in a communication network, such as the first network 198 or the second network 199, may be selected by, for example, the communication module 190 from the plurality of antennas. The signal or power may be transmitted or received between the communication module 190 and the external electronic device via the at least one selected antenna. According to an embodiment, another component (e.g., a radio frequency integrated circuit (RFIC)) other than the radiating element may be additionally formed as a part of the antenna module 197.

According to an embodiment, the antenna module 197 may form a mmWave antenna module. According to an embodiment, the mmWave antenna module may include a PCB, an RFIC disposed on a first surface (e.g., a bottom surface) of the PCB or adjacent to the first surface and capable of supporting a designated a high-frequency band (e.g., the mmWave band), and a plurality of antennas (e.g., array antennas) disposed on a second surface (e.g., a top or a side surface) of the PCB, or adjacent to the second surface and capable of transmitting or receiving signals in the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 and 104 may be a device of the same type as or a different type from the electronic device 101. According to an embodiment, all or some of operations to be executed by the electronic device 101 may be executed at one or more external electronic devices (e.g., the external electronic devices 102 and 104, and the server 108). For example, if the electronic device 101 is to perform a function or a service automatically, or in response to a request from a user or another device, the electronic device 101, instead of, or in addition to, executing the function or the service, may request one or more external electronic devices to perform at least a portion of the function or the service. The one or more external electronic devices receiving the request may perform the at least part of the function or the service requested, or an additional function or an additional service related to the request, and may transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or MEC. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

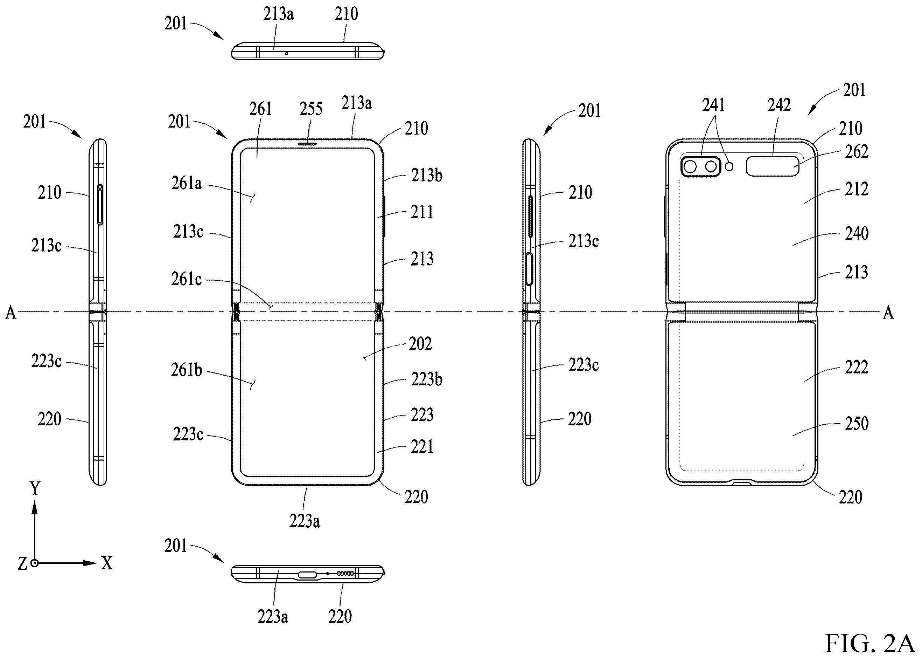

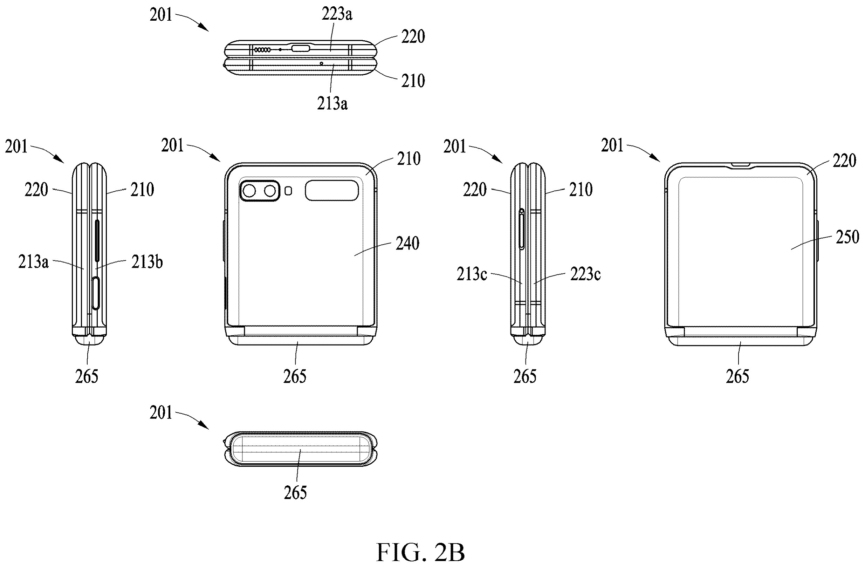

FIG. 2A is a view illustrating an electronic device in an unfolded state, according to various embodiments. FIG. 2B is a view illustrating an electronic device in a folded state, according to various embodiments.

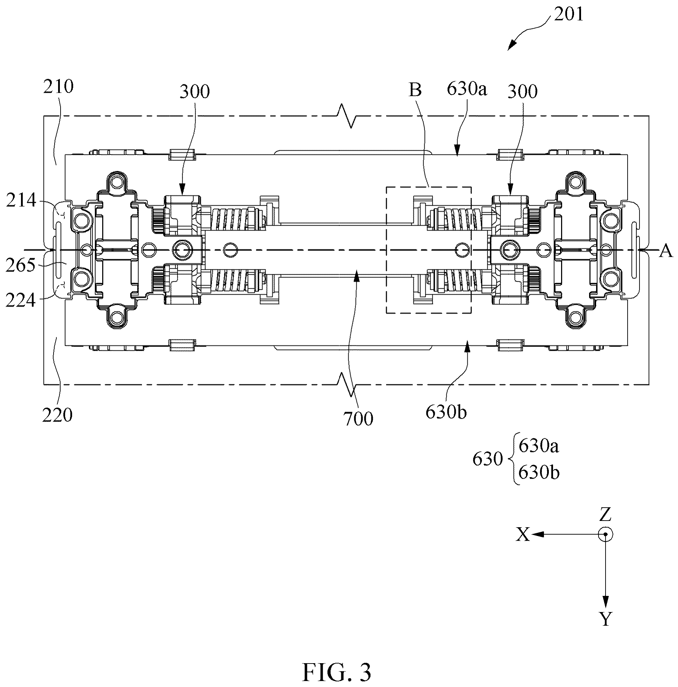

Referring to FIGS. 2A and 2B, an electronic device 201 according to an embodiment may include a pair of housings 210 and 220 rotatably coupled to each other through a hinge assembly (e.g., a hinge 300 of FIG. 3) to be folded with respect to each other, a hinge housing 265 for covering foldable portions of the pair of housings 210 and 220, and a display 261 (e.g., a flexible display or a foldable display) disposed in a space formed by the pair of housings 210 and 220. In the disclosure, a surface on which the display 261 is disposed may be defined as a front surface of the electronic device 201, and a surface opposite to the front surface may be defined as a rear surface of the electronic device 201. In addition, a surface surrounding a space between the front surface and the rear surface may be defined as a side surface of the electronic device 201.

In an embodiment, the electronic device 201 may include a first housing 210, a second housing 220, a first rear cover 240, and a second rear cover 250. The pair of housings 210 and 220 of the electronic device 201 are not limited to the shapes or the combination and/or coupling of components shown in FIGS. 2A and 2B, and may be implemented in other shapes or by another combination and/or coupling of components.

In an embodiment, the first housing 210 and the second housing 220 may be disposed on both sides (e.g., an upper portion and a lower portion) with respect to a folding axis A, and may be disposed substantially symmetrically with respect to the folding axis A. In an embodiment, an angle and/or a distance between the first housing 210 and the second housing 220 may vary depending on whether the electronic device 201 is in an unfolded state, a folded state, or an intermediate state.

In an embodiment, the first housing 210 may be connected to a first side of the hinge assembly (e.g., the hinge assembly 300 of FIG. 3) in the unfolded state of the electronic device 201. The first housing 210 may include a first surface 211 facing the front surface of the electronic device 201, a second surface 212 facing a direction opposite to the first surface 211, and a first side portion 213 enclosing at least a portion of a space between the first surface 211 and the second surface 212. The first side portion 213 may include a first side surface 213a disposed substantially in parallel with the folding axis A, a second side surface 213b extending in a direction substantially perpendicular to the folding axis A from one end of the first side surface 213a, and a third side surface 213c extending in a direction substantially perpendicular to the folding axis A from another end of the first side surface 213a and substantially parallel to the second side surface 213b. The second housing 220 may be connected to a second side of the hinge assembly (e.g., the hinge assembly 300 of FIG. 3) in the unfolded state of the electronic device 201. The second housing 220 may include a third surface 221 facing the front surface of the electronic device 201, a fourth surface 222 facing a direction opposite to the third surface 221, and a second side portion 223 enclosing at least a portion of a space between the third surface 221 and the fourth surface 222. The second side portion 223 may include a fourth side surface 223a disposed substantially in parallel with the folding axis A, a fifth side surface 223b extending in a direction substantially perpendicular to the folding axis A from one end of the fourth side surface 223a, and a sixth side surface 223c extending in a direction substantially perpendicular to the folding axis A from another end of the fourth side surface 223a and substantially parallel to the fifth side surface 223b. The first surface 211 and the third surface 221 may face each other when the electronic device 201 is in the folded state.

In an embodiment, the electronic device 201 may include a recessed accommodating portion 202 for accommodating the display 261 through the structural coupling of the first housing 210 and the second housing 220. The accommodating portion 202 may have substantially the same size as the display 261.

In an embodiment, at least a portion of the first housing 210 and the second housing 220 may be formed of a metal material or a non-metal material having a predetermined magnitude of rigidity appropriate to support the display 261.

In an embodiment, the electronic device 201 may include a sound output module 255 (e.g., the sound output module 155 of FIG. 1) disposed through at least a partial area of the first surface 211.

In an embodiment, the first rear cover 240 may be disposed on the second surface 212 of the first housing 210 and may have a substantially rectangular periphery. At least a portion of the periphery of the first rear cover 240 may be surrounded by the first housing 210. The second rear cover 250 may be disposed on the fourth surface 222 of the second housing 220 and may have a substantially rectangular periphery. At least a portion of the periphery of the second rear cover 250 may be surrounded by the second housing 220.

In an embodiment, the first rear cover 240 and the second rear cover 250 may have substantially symmetrical shapes with respect to the folding axis A. In an embodiment, the first rear cover 240 and the second rear cover 250 may have different shapes.

In an embodiment, the first housing 210 and the first rear cover 240 may be detachably connected, coupled, or joined to each other and the second housing 220 and the second rear cover 250 may be detachably connected, coupled, or joined to each other. In an embodiment, the first housing 210 and the first rear cover 240 may be integrally formed, and the second housing 220 and the second rear cover 250 may be integrally formed.

In an embodiment, the first housing 210, the second housing 220, the first rear cover 240, and the second rear cover 250 may provide a space in which various components (e.g., a PCB of FIG. 1, the antenna module 197, the sensor module 176 of FIG. 1, or the battery 189 of FIG. 1) of the electronic device 201 may be arranged through a structure in which the first housing 210, the second housing 220, the first rear cover 240, and the second rear cover 250 are coupled to one another. In an embodiment, at least one component may be visually exposed on the rear surface of the electronic device 201. For example, at least one component may be visually exposed through a first rear area 241 of the first rear cover 240. Here, the component may include a proximity sensor, a rear camera module, and/or a flash. In an embodiment, at least a portion of a sub-display 262 may be visually exposed through a second rear area 242 of the first rear cover 240.

In an embodiment, the display 261 may be disposed in the accommodating portion 202 formed by the pair of housings 210 and 220. For example, the display 261 may be arranged to occupy substantially most of the front surface of the electronic device 201. The front surface of the electronic device 201 may include an area in which the display 261 is disposed, and a partial area (e.g., a periphery area) of the first housing 210 and a partial area (e.g., a periphery area) of the second housing 220, which are adjacent to the display 261. The rear surface of the electronic device 201 may include the first rear cover 240, a partial area (e.g., a periphery area) of the first housing 210 adjacent to the first rear cover 240, the second rear cover 250, and a partial area (e.g., a periphery area) of the second housing 220 adjacent to the second rear cover 250. In an embodiment, the display 261 may be a display in which at least one area is deformable into a planar surface or a curved surface. In an embodiment, the display 261 may include a folding area 261c, a first area 261a on a first side (e.g., an upper portion) of the folding area 261c, and a second area 261b on a second side (e.g., a lower portion) of the folding area 261c. The first housing 210 may be configured to support the first area 261a, and the second housing 220 may be configured to support the second area 261b. The first area 261a may be positioned on the first surface 211 of the first housing 210, and the second area 261b may be positioned on the third surface 221 of the second housing 220. However, the area division of the display 261 is merely an example, and the display 261 may be divided into a plurality of areas depending on the structure or functions of the display 261. For example, as shown in FIG. 2A, the display 261 may be divided into areas based on the folding axis A or the folding area 261c extending in parallel to an x-axis, or the display 261 may be divided into areas based on another folding area (e.g., a folding area extending in parallel to an y-axis) or another folding axis (e.g., a folding axis parallel to the y-axis). The area division of the display 261 described above is merely physical division based on the pair of housings 210 and 220 and the hinge assembly (e.g., the hinge assembly 300 of FIG. 3), and the display 261 may display substantially one screen through the pair of housings 210 and 220 and the hinge assembly (e.g., the hinge assembly 300 of FIG. 3). In an embodiment, the first area 261a and the second area 261b may have substantially symmetrical shapes with respect to the folding area 261c.

In an embodiment, the hinge housing 265 may be arranged between the first housing 210 and the second housing 220 and configured to cover the hinge assembly (e.g., the hinge assembly 300 of FIG. 3). The hinge housing 265 may be hidden by at least a portion of the first housing 210 and the second housing 220 or exposed to the outside according to the operational state of the electronic device 201. For example, when the electronic device 201 is in an unfolded state as shown in FIG. 2A, the hinge housing (e.g., the hinge housing 265 of FIG. 2B) may be hidden by the first housing 210 and the second housing 220 and not exposed to the outside, and when the electronic device 201 is in a folded state as shown in FIG. 2B, at least a portion of the hinge housing 265 may be exposed to the outside between the first housing 210 and the second housing 220. Meanwhile, when the electronic device 201 is in an intermediate state in which the first housing 210 and the second housing 220 form an angle with each other, at least a portion of the hinge housing 265 may be exposed to the outside between the first housing 210 and the second housing 220. For example, an area of the hinge housing 265 exposed to the outside may be smaller than the area of the hinge housing 265 exposed when the electronic device 201 is in the folded state. In an embodiment, the hinge housing 265 may have a curved surface.

In the operation of the electronic device 201 according to an embodiment, when the electronic device 201 is in an unfolded state (e.g., the state of the electronic device 201 of FIG. 2A), the first housing 210 and the second housing 220 may form a first angle (e.g., about 180 degrees) with each other, and the first area 261a and the second area 261b of the display 261 may be oriented in substantially the same direction. The folding area 261c of the display 261 may be on substantially the same plane as the first area 261a and the second area 261b. In an embodiment, when the electronic device 201 is in the unfolded state, as the first housing 210 rotates at a second angle (e.g., about 360 degrees) relative to the second housing 220, the second surface 212 and the fourth surface 222 may face each other. Meanwhile, when the electronic device 201 is in the folded state (e.g., the state of the electronic device 201 of FIG. 2B), the first housing 210 and the second housing 220 may face each other. The first housing 210 and the second housing 220 may form an angle of about 0 degrees to about 10 degrees, and the first area 261a and the second area 261b of the display 261 may face each other. At least a portion of the folding area 261c of the display 261 may be deformed into a curved surface. Meanwhile, when the electronic device 201 is in the intermediate state, the first housing 210 and the second housing 220 may form a predetermined angle with each other. An angle (e.g., a third angle, about 90 degrees) formed by the first area 261a and the second area 261b of the display 261 may be greater than that when the electronic device 201 is in the folded state and less than that when the electronic device 201 is in the unfolded state. At least a portion of the folding area 261c of the display 261 may be deformed into a curved surface. For example, a curvature of the curved surface of the folding area 261c may be smaller than a curvature of the curved surface of the folding area 261c when the electronic device 201 is in the folded state.

Meanwhile, the various embodiments of the electronic device described herein are not limited to a form factor of the electronic device 201 described with reference to FIGS. 2A and 2B, and may also apply to electronic devices with various form factors.

The electronic device according to various embodiments may be one of various types of electronic devices. The electronic device may include, for example, a portable communication device (e.g., a smartphone), a computer device, a portable multimedia device, a portable medical device, a camera, a wearable device, or a home appliance device. According to an embodiment of the disclosure, the electronic device is not limited to those described above.

It should be appreciated that various embodiments of the present disclosure and the terms used therein are not intended to limit the technological features set forth herein to particular embodiments and include various changes, equivalents, or replacements for a corresponding embodiment. In connection with the description of the drawings, like reference numerals may be used for similar or related components. It is to be understood that a singular form of a noun corresponding to an item may include one or more of the things, unless the relevant context clearly indicates otherwise. As used herein, "A or B", "at least one of A and B", "at least one of A or B", "A, B or C", "at least one of A, B and C", and "at least one of A, B, or C," may include any one of the items listed together in the corresponding one of the phrases, or all possible combinations thereof. Terms such as "1^{st}", "2^{nd}", or "first" or "second" may simply be used to distinguish the component from other components in question, and do not limit the components in other aspects (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., by wire), wirelessly, or via a third element.

As used in connection with embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, According to an embodiment, the module may be implemented in a form of an application-specific integrated circuit (ASIC).

Various embodiments as set forth herein may be implemented as software (e.g., the program 140) including one or more instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read-only memory (CD-ROM)), or be distributed (e.g., downloaded or uploaded) online via an application store (e.g., PlayStore^{™}), or between two user devices (e.g., smartphones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to an embodiment, operations performed by the module, the program, or another component may be carried out sequentially, in parallel, repeatedly, or heuristically, or one or more of the operations may be executed in a different order or omitted, or one or more other operations may be added.

FIG. 3 is a plan view of the inside of an electronic device illustrating a state in which a hinge assembly is disposed in the electronic device according to an embodiment.

Referring to FIG. 3, the electronic device 201 (e.g., the electronic device 101 of FIG. 1) according to an embodiment may be a foldable electronic device. For example, the electronic device 201 may be folded or unfolded with respect to the folding axis A. However, FIG. 3 is merely an example, and the size, shape, structure, and/or the folding axis of the electronic device 201 are not limited thereto. For example, although the electronic device 201 shown in FIG. 3 may include the folding axis A in an X direction (e.g., a short side direction), an electronic device according to an embodiment may include a folding axis in a Y direction (e.g., a long side direction).

The electronic device 201 according to an embodiment may include the first housing 210, the second housing 220, the hinge housing 265, a display (not shown) (e.g., the display module 160 of FIG. 1 or the display 261 of FIG. 2A), the hinge assembly 300, a wing plate 630, and/or a cover member 700.

In an embodiment, the first housing 210, the second housing 220, and the hinge housing 265 may form at least a portion of the exterior of the electronic device 201. The first housing 210 and the second housing 220 may be foldably connected to each other by the hinge assembly 300. An angle or distance between the first housing 210 and the second housing 220 may vary depending on whether the electronic device 201 is in a flat or unfolded state, a folded state, or an intermediate state. The intermediate state described above may include all states between the unfolded state and the folded state. The hinge housing 265 may be disposed between the first housing 210 and the second housing 220 to provide a space in which an internal component (e.g., the hinge assembly 300) is disposed. For example, the hinge housing 265 may be configured to cover the hinge assembly 300 from a rear surface (e.g., a surface in a -Z direction) such that the hinge assembly 300 is not exposed to the outside.

In an embodiment, the hinge assembly 300 may be disposed between the first housing 210 and the second housing 220 to connect the first housing 210 and the second housing 220. The hinge assembly 300 may be disposed inside the hinge housing 265. For example, the hinge assembly 300 may be fixedly connected to the hinge housing 265. A plurality of hinge assemblies 300 may be provided. The plurality of hinge assemblies 300 may be spaced apart along the folding axis A (e.g., the X direction). For example, as shown in FIG. 3, two hinge assemblies 300 may be spaced apart along the folding axis A. However, this is merely an example, and the number of hinge assemblies 300 is not limited thereto. The hinge assembly 300 may implement folding or unfolding operations of the electronic device 201. The hinge assembly 300 may operate between a folded state and an unfolded state, in which the first housing 210 and the second housing 220 face each other in the folded state and the first housing 210 and the second housing 220 do not face each other in the unfolded state. The hinge assembly 300 may generate a force to maintain a specific folded state of the electronic device 201. For example, when the electronic device 201 is in the folded state, the hinge assembly 300 may generate a force (e.g., a close detent force) to maintain the folded state of the electronic device 201. When the electronic device 201 is in the unfolded state, the hinge assembly 300 may generate a force (e.g., an open detent force) to maintain the unfolded state of the electronic device 201. When the electronic device 201 is in the intermediate state, the hinge assembly 300 may generate a force (e.g., a free-stop force) to maintain the intermediate state of the electronic device 201.

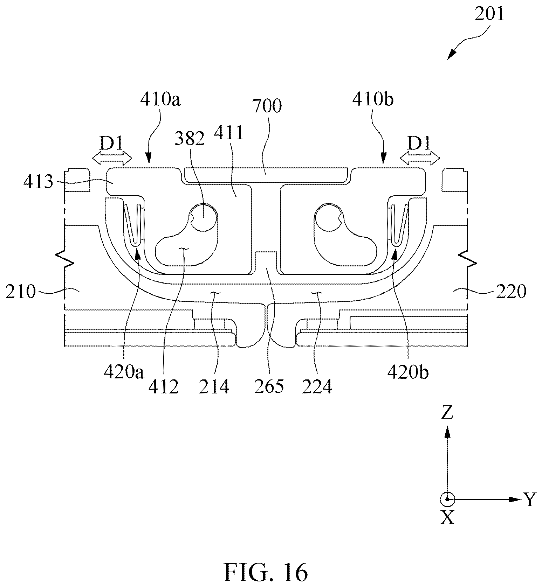

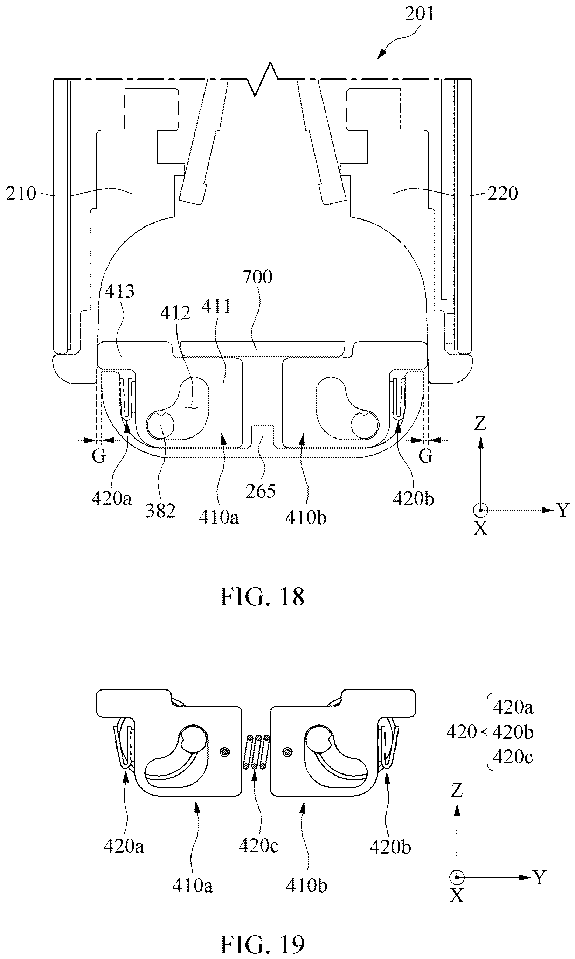

In an embodiment, the first housing 210 may include a first seating portion 214 (e.g., the first seating portion 214 of FIG. 16), and the second housing 220 may include a second seating portion 224 (e.g., the second seating portion 224 of FIG. 16). The first seating portion 214 and the second seating portion 224 may be formed at a portion where the first housing 210 and the second housing 220 are positioned adjacent to each other. For example, the first seating portion 214 and the second seating portion 224 may be formed to be recessed in the first housing 210 and the second housing 220, respectively. For example, the first seating portion 214 may include a surface and/or a space formed to be recessed in the first housing 210. For example, the second seating portion 224 may include a surface and/or a space formed to be recessed in the second housing 220. As shown in FIG. 3 and FIG. 16 to be described below, the hinge housing 265 may be positioned on the first seating portion 214 and the second seating portion 224 in the unfolded state of the electronic device 201. Meanwhile, as shown in FIG. 2B and FIG. 18 to be described below, at least a portion of the hinge housing 265 may be exposed to the outside in the folded state of the electronic device 201.

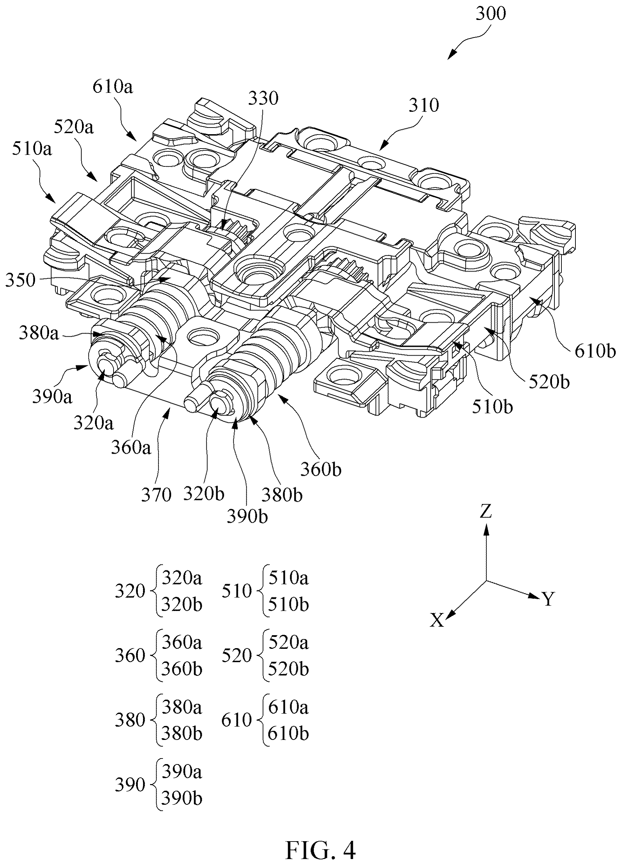

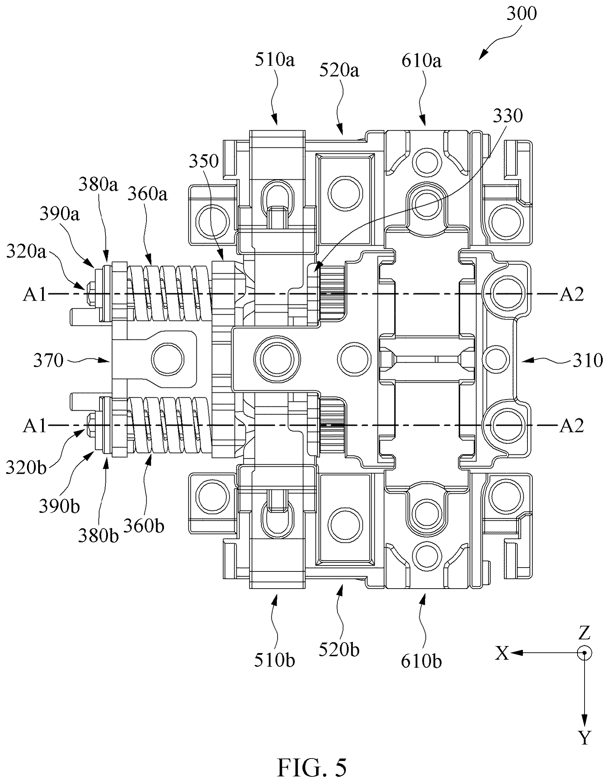

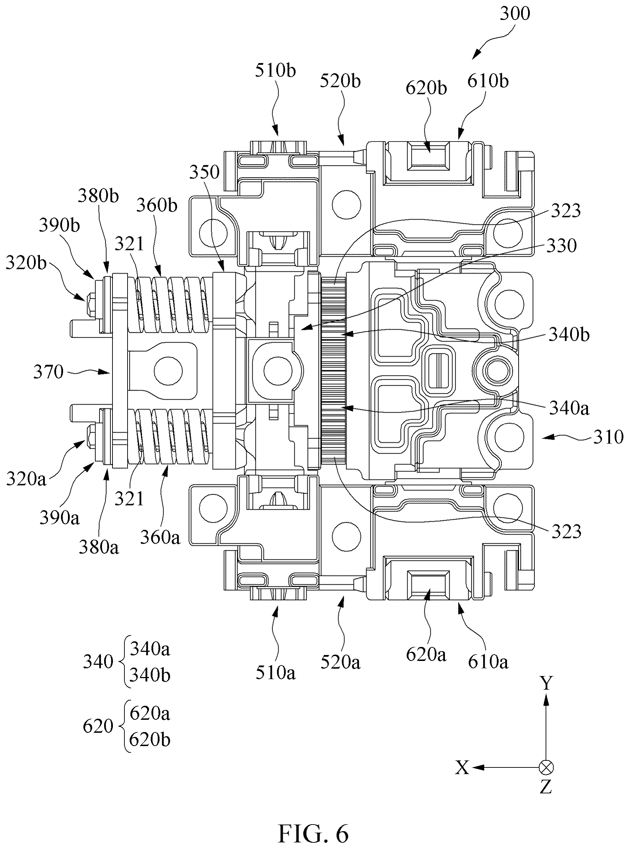

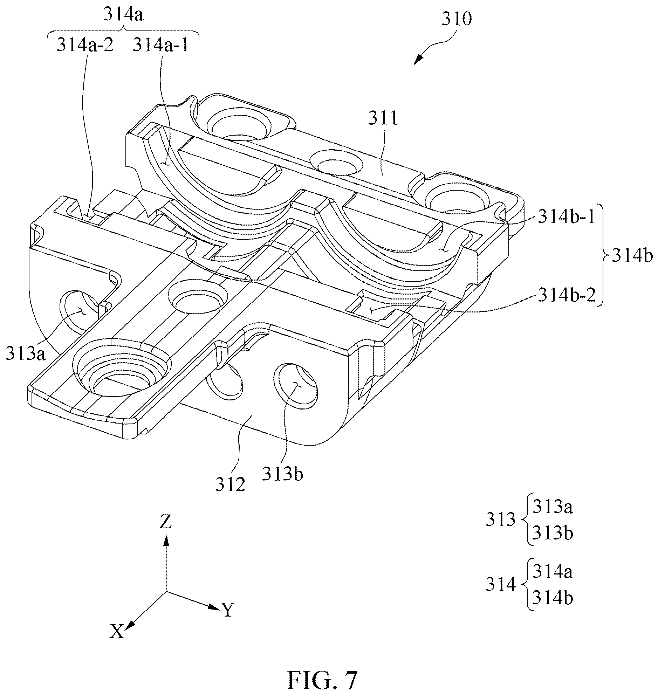

FIG. 4 is a perspective view illustrating an unfolded state of a hinge assembly according to an embodiment. FIG. 5 is a front view illustrating an unfolded state of a hinge assembly according to an embodiment. FIG. 6 is a rear view illustrating an unfolded state of a hinge assembly according to an embodiment. FIG. 7 is a perspective view illustrating a hinge bracket according to an embodiment.

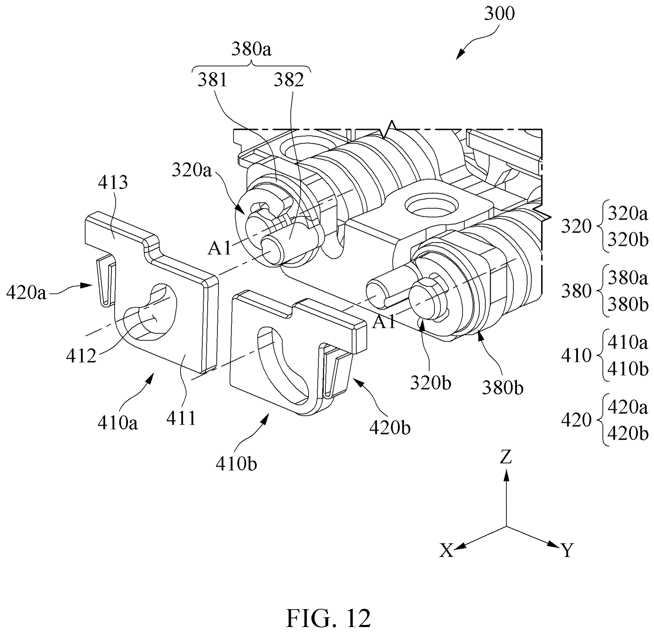

Referring to FIGS. 3 to 7, the hinge assembly 300 according to an embodiment may include a hinge bracket 310, a shaft 320, a gear bracket 330, an idle gear 340, a cam member 350, a spring 360, a shaft bracket 370, a rotation protrusion member 380, a separation prevention member 390, a sliding member (e.g., a sliding member 410 of FIG. 12), an elastic member (e.g., an elastic member 420 of FIG. 12), an arm member 510, a rotation bracket 520, a wing member 610, and/or a pin member 620.

In an embodiment, the hinge bracket 310 may be configured to be fixedly positioned within an electronic device (e.g., the electronic device 201 of FIG. 2A). For example, the hinge bracket 310 may be fixedly connected to the hinge housing 265. For example, each component of the hinge assembly 300 (e.g., the arm member 510, the rotation bracket 520, and/or the wing member 610) may be configured to move relative to the hinge bracket 310 which has a fixed position.

In an embodiment, the hinge bracket 310 may include a first hinge bracket body 311, a second hinge bracket body 312, a shaft coupling portion 313, and a recessed wing rail 314.

In an embodiment, the first hinge bracket body 311 and the second hinge bracket body 312 may form an exterior of the hinge bracket 310. The first hinge bracket body 311 and the second hinge bracket body 312 may be positioned adjacent to each other to form the hinge bracket 310. For example, the first hinge bracket body 311 may form one side portion (e.g., a portion in a -X direction) of the hinge bracket 310, and the second hinge bracket body 312 may form the other side portion (e.g., a portion in a +X direction) of the hinge bracket 310. However, this is an example, and in an embodiment, the hinge bracket 310 may be formed as a single body.

In an embodiment, the shaft coupling portion 313 may be a portion for coupling the shaft 320 to the hinge bracket 310. For example, the shaft coupling portion 313 may be formed at one side end portion (e.g., an end portion in a +X direction) of the hinge bracket body 312. For example, the shaft coupling portion 313 may be formed as a hole for the shaft 320 to be inserted. For example, the shaft coupling portion 313 may be formed in a direction of a first axis A1. The shaft 320 may be rotatably inserted into the shaft coupling portion 313. A pair of shaft coupling portions 313 may be formed. For example, the shaft coupling portion 313 may include a first shaft coupling portion 313a and a second shaft coupling portion 313b. The first shaft coupling portion 313a and the second shaft coupling portion 313b may be spaced apart from each other in a width direction (e.g., the Y direction). A first shaft 320a and a second shaft 320b may be inserted into the first shaft coupling portion 313a and the second shaft coupling portion 313b, respectively.

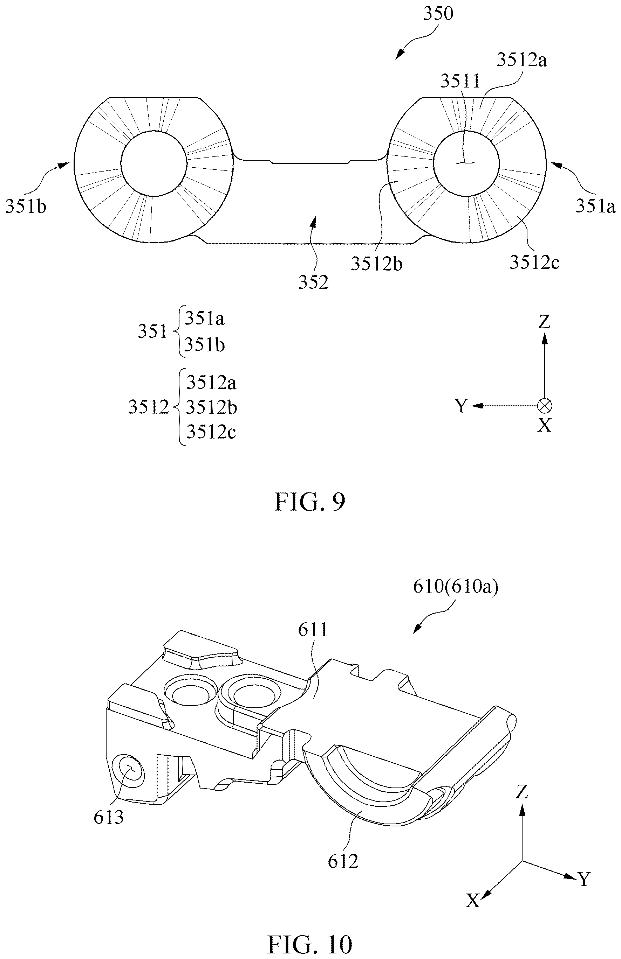

In an embodiment, the recessed wing rail 314 may be formed on the first hinge bracket body 311 and/or the second hinge bracket body 312. The recessed wing rail 314 may be a component that helps the wing member 610 to be rotatably connected to the hinge bracket 310. The recessed wing rail 314 may interoperate with a protruding wing rail (e.g., a protruding wing rail 612 of FIG. 10) of the wing member 610 to be described below. For example, the recessed wing rail 314 may have an arc shape having a second axis A2 as a center. For example, the recessed wing rail 314 may be formed to be recessed into the first hinge bracket body 311 and the second hinge bracket body 312 so that the wing member 610 is inserted. A pair of recessed wing rails 314 may be formed. For example, the recessed wing rail 314 may include a first recessed wing rail 314a and a second recessed wing rail 314b. For example, the first recessed wing rail 314a and the second recessed wing rail 314b may be positioned parallel in the width direction (e.g., the Y direction). A portion 314a-1 of the first recessed wing rail 314a may be formed on the first hinge bracket body 311, and another portion 314a-2 of the first recessed wing rail 314a may be formed on the second hinge bracket body 312. A portion 314b-1 of the second recessed wing rail 314b may be formed on the first hinge bracket body 311, and another portion 314b-2 of the second recessed wing rail 314b may be formed on the second hinge bracket body 312. The first recessed wing rail 314a and the second recessed wing rail 314b may interoperate with protruding wing rails (e.g., the protruding wing rails 612 of FIG. 10) of a first wing member 610a and a second wing member 610b, respectively. However, the positions, the sizes, the numbers, and/or the shapes of the first hinge bracket body 311, the second hinge bracket body 312, the shaft coupling portion 313, and the recessed wing rail 314 shown in the drawings are examples, and are not limited thereto.

In an embodiment, the shaft 320 may be rotatably connected to the hinge bracket 310 about the first axis A1. For example, the first axis A1 may refer to a longitudinal direction of the shaft 320. The shaft 320 may include a shaft body 321 and a gear portion 323. The shaft body 321 may be a portion formed in the longitudinal direction (e.g., the X direction). The shaft body 321 may be rotatably inserted into the shaft coupling portion 313 formed in the hinge bracket 310. The gear portion 323 may be formed to protrude from the shaft body 321 to have a gear structure. For example, the gear portion 323 may be integrally formed with the shaft body 321. A pair of shafts 320 may be provided. For example, the shaft 320 may include the first shaft 320a and the second shaft 320b. The first shaft 320a and the second shaft 320b may be rotatably inserted into the first shaft coupling portion 313a and the second shaft coupling portion 313b, respectively.

In an embodiment, the idle gear 340 may be positioned between the gear portion 323 of the first shaft 320a and the gear portion 323 of the second shaft 320b. For example, a pair of idle gears 340 may be provided. The idle gear 340 may include a first idle gear 340a and a second idle gear 340b. The first idle gear 340a and the second idle gear 340b may be adjacent to each other and gear interoperation between the first idle gear 340a and the second idle gear 340b may be implemented. The first idle gear 340a may interoperate with the gear portion 323 of the first shaft 320a, and the second idle gear 340b may interoperate with the gear portion 323 of the second shaft 320b. The first idle gear 340a and the second idle gear 340b may implement interoperation between the motion of the first housing 210 and the motion of the second housing 220. For example, the first idle gear 340a and the second idle gear 340b may synchronize the rotation of the first shaft 320a with the rotation of the second shaft 320b. When the shaft 320 is rotatably connected to the hinge bracket 310, the gear bracket 330 may be inserted into the shaft 320 to pass through the shaft 320. The gear bracket 330 may fix the position of the idle gear 340. The idle gear 340 may be rotatably connected to each of the gear bracket 330 and the hinge bracket 310. The structure that implements interoperation between the motion of the first housing 210 and the motion of the second housing 220 is not limited thereto. For example, in an embodiment, the hinge assembly 300 may implement interoperation between the motion of the first housing 210 and the motion of the second housing 220 through a spiral interoperation structure.

In an embodiment, the arm member 510 may be connected to the shaft 320 to integrally rotate with the shaft 320 with respect to the hinge bracket 310. The arm member 510 may rotate about the first axis A1, which is the longitudinal direction of the shaft 320, with respect to the hinge bracket 310. For example, the shaft 320 may be pressed in and connected to the arm member 510. A pair of arm members 510 may be provided. For example, the arm member 510 may include a first arm member 510a and a second arm member 510b. The first arm member 510a and the second arm member 510b may be connected to the first shaft 320a and the second shaft 320b, respectively. In an embodiment, the arm member 510 may be formed integrally with the shaft 320.

In an embodiment, the cam member 350 may be inserted into the shaft 320 such that cam interoperation between the arm member 510 and the cam member 350 is implemented. For example, the cam member 350 may face the arm member 510. As cam interoperation between the cam member 350 and the arm member 510 is implemented, the cam member 350 may implement a detent force and/or a free-stop force.

In an embodiment, the spring 360 may be inserted into the shaft 320 while the cam member 350 is inserted into the shaft 320. The spring 360 may press the cam member 350 toward the arm member 510. For example, the spring 360 may include a cylindrical spring. A pair of springs 360 may be provided. For example, the spring 360 may include a first spring 360a and a second spring 360b. The first spring 360a and the second spring 360b may be inserted into the first shaft 320a and the second shaft 320b, respectively. Meanwhile, this is an example, and the spring 360 may include a plate spring. The elastic force of the spring 360 may implement the detent force and/or the free-stop force of the hinge assembly 300.

In an embodiment, in a state in which the spring 360 is inserted into the shaft 320, the shaft bracket 370 may be inserted into the shaft 320. For example, both the first shaft 320a and the second shaft 320b may be inserted into the shaft bracket 370. The shaft bracket 370 may maintain the distance between the first shaft 320a and the second shaft 320b. For example, the shaft bracket 370 may be fixedly connected to the hinge housing 265.

In an embodiment, in a state in which the shaft bracket 370 is inserted into the shaft 320, the rotation protrusion member 380 and the separation prevention member 390 may be inserted into an end portion (e.g., an end portion in the +X direction) of the shaft 320. The rotation protrusion member 380 may be connected to one end portion (e.g., an end portion in the -X direction) of the shaft to rotate integrally with the shaft 320. The separation prevention member 390 may be inserted into one end portion (e.g., the end portion in the -X direction) of the shaft to prevent components (e.g., the gear bracket 330, the arm member 510, the cam member 350, the spring 360, the shaft bracket 370, and/or the rotation protrusion member 380) inserted into the shaft 320 from separating from the shaft 320. For example, the rotation protrusion member 380 may include a washer plate. For example, the separation prevention member 390 may include an e-ring and/or a washer. However, this is merely an example, and the types of the rotation protrusion member 380 and/or the separation prevention member 390 are not limited thereto. A plurality of rotation protrusion members 380 and a plurality of separation prevention members 390 may be provided. For example, the rotation protrusion member 380 may include a first rotation protrusion member 380a and a second rotation protrusion member 380b. For example, the separation prevention member 390 may include a first separation prevention member 390a and a second separation prevention member 390b. The first rotation protrusion member 380a and the first separation prevention member 390a may be inserted into the first shaft 320a, and the second rotation protrusion member 380b and the second separation prevention member 390b may be inserted into the second shaft 320b.

In an embodiment, the rotation bracket 520 may be slidably and/or rotatably connected to the arm member 510. A pair of rotation brackets 520 may be provided. For example, the rotation bracket 520 may include a first rotation bracket 520a and a second rotation bracket 520b. In an embodiment, the first rotation bracket 520a may be slidably and/or rotatably connected to the first arm member 510a, and the second rotation bracket 520b may be slidably and/or rotatably connected to the second arm member 510b. The rotation bracket 520 may be connected to the first housing 210 or the second housing 220. For example, the first rotation bracket 520a may be connected to the first housing 210, and the second rotation bracket 520b may be connected to the second housing 220. The rotation bracket 520 may be connected to the wing member 610 by the pin member 620. The rotation bracket 520 and the wing member 610 may be relatively rotatably connected by the pin member 620. For example, a first pin member 620a may rotatably connect the first rotation bracket 520a and the first wing member 610a, and a second pin member 620b may rotatably connect the second rotation bracket 520b and the second wing member 610b.

In an embodiment, the wing member 610 may be rotatably connected to the hinge bracket 310. The wing member 610 may be rotatably connected to the hinge bracket 310 through the recessed wing rail 314 of the hinge bracket 310. The wing member 610 may rotate about the second axis A2, which is a center axis of the recessed wing rail 314, with respect to the hinge bracket 310. A pair of wing members 610 may be provided. For example, the wing member 610 may include the first wing member 610a and the second wing member 610b. The first wing member 610a and the second wing member 610b may be connected to the first recessed wing rail 314a and the second recessed wing rail 314b, respectively.

In an embodiment, a wing plate (e.g., the wing plate 630 of FIG. 3) may be connected to the wing member 610. The wing plate 630 may support at least a portion of a display (e.g., the display 261 of FIG. 2A). A pair of wing plates 630 may be provided. The wing plate 630 may include a first wing plate (e.g., a first wing plate 630a of FIG. 3) and a second wing plate (e.g., a second wing plate 630b of FIG. 3). The first wing plate 630a and the second wing plate 630b may support a first area (e.g., the first area 261a of FIG. 2A) and a second area (e.g., the second area 261b of FIG. 2A) of the display 261, respectively. For example, the first wing plate 630a and the second wing plate 630b may be connected to the first wing member 610a and the second wing member 610b, respectively.

In an embodiment, a cover member (e.g., the cover member 700 of FIG. 3) may be positioned to cover the hinge assembly 300 from the upper side (e.g., a +Z direction). The cover member 700 may be positioned in a central area of the hinge assembly 300. For example, as shown in FIG. 3, a single cover member 700 may be positioned to cover both of a pair of hinge assemblies 300. For example, the cover member 700 may support at least a portion (e.g., the folding area 261c of FIG. 2A) of a display (e.g., the display 261 of FIG. 2A) in the unfolded state of the electronic device 201. Meanwhile, the wing plate 630 and/or the cover member 700 is a component connected to the hinge assembly 300 and may be understood as a sub-component of the hinge assembly 300.

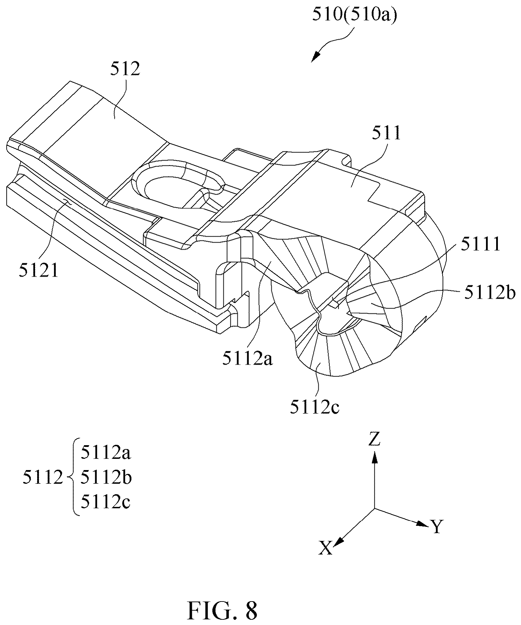

FIG. 8 is a perspective view illustrating a first arm member according to an embodiment.

Hereinafter, the arm member 510 will be described based on the first arm member 510a with reference to FIGS. 3 to 6 and 8. The second arm member 510b may be substantially symmetrical to the first arm member 510a based on a folding axis (e.g., the folding axis A of FIG. 3).

In an embodiment, the arm member 510 may include an arm cam 511 and an arm body 512.

In an embodiment, the arm cam 511 may be a portion in which a through hole 5111 and a cam crest 5112 are formed. The through hole 5111 may be a hole to which the shaft 320 is inserted. For example, a protrusion is formed on an inner circumferential surface of the through hole 5111 such that the shaft 320 may be pressed into the through hole 5111. The cam crest 5112 may be formed to protrude in a direction of the first axis A1 (e.g., the X direction). The cam crest 5112 may be formed to have a profile with a first inclined area, a flat area, and a second inclined area. However, this is for ease of description. The first inclined area, the flat area, and the second inclined area may be substantially and smoothly connected to each other to form a curved surface. A plurality of cam crests 5112 may be formed. For example, the cam crest 5112 may include a first cam crest 5112a, a second cam crest 5112b, and a third cam crest 5112c. The plurality of cam crests 5112 may be spaced apart from each other along the circumference of the through hole 5111. For example, a trough may be substantially formed between the plurality of cam crests 5112.

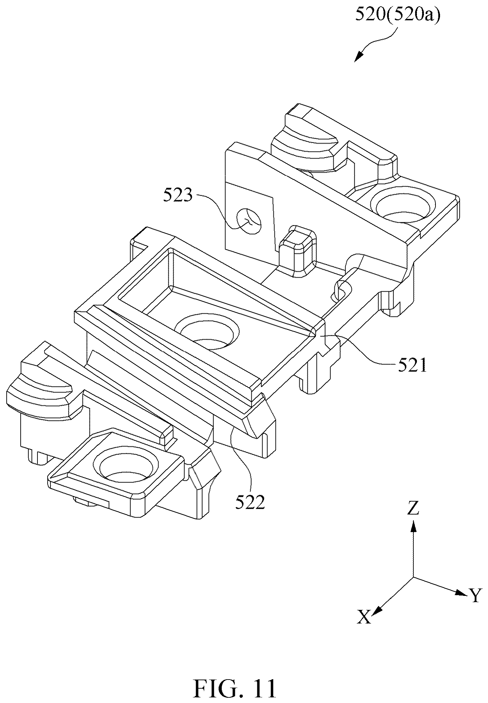

In an embodiment, the arm body 512 may be formed to extend from the arm cam 511. The arm body 512 may be a portion to which the rotation bracket 520 is slidably and/or rotatably connected. For example, a recessed arm rail 5121 may be formed in the arm body 512. The rotation bracket 520 may be slidably connected to the recessed arm rail 5121. For example, the recessed arm rail 5121 may interoperate with a protruding arm rail (e.g., a protruding arm rail 522 of FIG. 11) of the rotation bracket 520. For example, the recessed arm rail 5121 may be formed to be recessed in the arm body 512 in the shape of a rail in the direction of the folding axis A (e.g., the X direction). The recessed arm rail 5121 may be substantially formed in a straight line or curved to have a curvature.

FIG. 9 is a front view illustrating a cam member according to an embodiment.

Referring to FIGS. 3 to 6, 8, and 9, in an embodiment, the cam member 350 may include a fixed cam 351 and a connecting body 352. The fixed cam 351 may be formed to substantially correspond to the arm cam 511 of the arm member 510. The fixed cam 351 may be a portion in which a through hole 3511 and a fixed cam crest 3512 are formed. The through hole 3511 may be a hole to which the shaft 320 is inserted. The fixed cam crest 3512 may be formed in the direction (e.g., the -X direction) toward the cam crest 5112 of the arm member 510. For example, the shape of the fixed cam crest 3512 may be substantially the same as or similar to the shape of the cam crest 5112 of the arm member 510. The fixed cam crest 3512 may be formed to have a profile with a first inclined area, a flat area, and a second inclined area. However, these areas area are defined for ease of description. The first inclined area, the flat area, and the second inclined area may be substantially and smoothly connected to each other to form a curved surface. A plurality of fixed cam crests 3512 may be formed. For example, the fixed cam crest 3512 may include a first fixed cam crest 3512a, a second fixed cam crest 3512b, and a third fixed cam crest 3512c. The plurality of fixed cam crests 3512 may be spaced apart from each other along the circumference of the through hole 3511. For example, a trough may be formed between the plurality of fixed cam crests 3512. Based on a state in which the hinge assembly 300 is fully unfolded or folded, the plurality of fixed cam crests 3512 may be positioned in a trough portion between the plurality of cam crests 5112 of the arm member 510. When the hinge assembly 300 is in an intermediate state, the plurality of fixed cam crests 3512 may be positioned such that the plurality of cam crests 5112 of the arm member 510 is in contact with a crest portion. A pair of fixed cam 351 may be formed. For example, the fixed cam 351 may include a first fixed cam 351a and a second fixed cam 351b. The first shaft 320a and the second shaft 320b may be inserted into the first fixed cam 351a and the second fixed cam 351b, respectively. Cam interoperation may be implemented between the first fixed cam 351a and the arm cam 511 of the first arm member 510a and between the second fixed cam 351b and the arm cam 511 of the second arm member 510b. The first fixed cam 351a may be connected to the second fixed cam 351b by the connecting body 352.

FIG. 10 is a perspective view illustrating a first wing member according to an embodiment.

Hereinafter, the wing member 610 will be described based on the first wing member 610a with reference to FIGS. 3 to 7, and 10. The second wing member 610b may be substantially symmetrical to the first wing member 610a based on a folding axis (e.g., the folding axis A of FIG. 3).

In an embodiment, the wing member 610 may include a wing body 611, the protruding wing rail 612, and/or a pin hole 613.

In an embodiment, the wing body 611 may be a portion that forms the exterior of the wing member 610. For example, the protruding wing rail 612 and/or the pin hole 613 may be formed in the wing body 611. The protruding wing rail 612 may interoperate with the recessed wing rail 314 of the hinge bracket 310. The wing member 610 may rotate with respect to the hinge bracket 310 by interoperation between the protruding wing rail 612 and the recessed wing rail 314. The protruding wing rail 612 may be formed in a shape corresponding to the recessed wing rail 314. For example, the protruding wing rail 612 may be formed to protrude from the wing body 611 in the direction of the second axis A2 (e.g., the X direction). Meanwhile, the designations of the protruding wing rail 612 and the recessed wing rail 314 are for descriptive purposes only, and in an embodiment, a wing rail may be formed to be recessed into the wing member 610 and a wing rail may be formed to protrude on the hinge bracket 310. The pin hole 613 may be formed to penetrate the wing body 611 in the direction (e.g., the X direction) parallel to the folding axis A. The pin hole 613 may be formed on a side opposite to the protruding wing rail 612. For example, the protruding wing rail 612 may be formed on one side portion (e.g., a portion in a +Y direction) of the wing body 611, and the pin hole 613 may be formed on the other side portion (e.g., a portion in a -Y direction) of the wing body 611. The pin hole 613 may be a hole into which a pin member (e.g., the pin member 620 of FIG. 6) is inserted.

FIG. 11 is a perspective view illustrating a first rotation bracket according to an embodiment.

Hereinafter, the rotation bracket 520 will be described based on the first rotation bracket 520a with reference to FIGS. 3 to 6, 8, 10, and 11. The second rotation bracket 520b may be substantially symmetrical to the first rotation bracket 520a based on a folding axis (e.g., the folding axis A of FIG. 3).

In an embodiment, the rotation bracket 520 may include a rotation bracket body 521, the protruding arm rail 522, and/or a pin hole 523.

In an embodiment, the rotation bracket body 521 may be a portion that forms the exterior of the rotation bracket 520. For example, the protruding arm rail 522 and/or the pin hole 523 may be formed in the rotation bracket body 521. The protruding arm rail 522 may interoperate with the recessed arm rail 5121 of the arm member 510. The rotation bracket 520 may slide and/or rotate with respect to the arm member 510 by interoperation between the recessed arm rail 5121 and the protruding arm rail 522. The protruding arm rail 522 may be formed in a shape corresponding to the recessed arm rail 5121. For example, the protruding arm rail 522 may be formed to protrude in a rail shape in the direction of the folding axis A (e.g., the X direction). Meanwhile, the designations of the protruding arm rail 522 and the recessed arm rail 5121 are for descriptive purposes only, and in an embodiment, an arm rail may be formed to be recessed into the rotation bracket 520 and an arm rail may be formed to protrude into the arm member 510. The pin hole 523 may be formed to penetrate the rotation bracket body 521 in a direction (e.g., the X direction) parallel to the folding axis A. The pin hole 523 may be formed on a side opposite to the protruding arm rail 522. For example, the protruding arm rail 522 may be formed on one side portion (e.g., a portion in the +X direction) of the rotation bracket body 521, and the pin hole 523 may be formed on the other side portion (e.g., a portion in the -X direction) of the rotation bracket body 521. The pin hole 523 may be a hole into which a pin member (e.g., the pin member 620 of FIG. 6) is inserted.

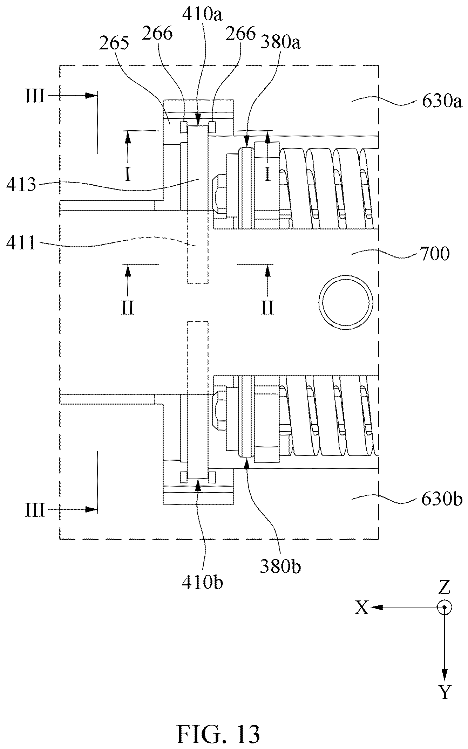

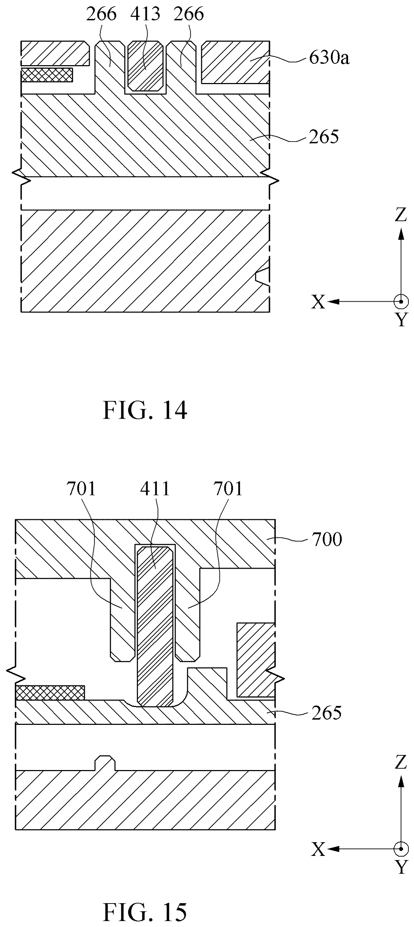

FIG. 12 is a partially exploded perspective view of a hinge assembly according to an embodiment. FIG. 13 is an enlarged view of a portion B of FIG. 3. FIG. 14 is a cross-sectional view taken along line I-I of FIG. 13. FIG. 15 is a cross-sectional view taken along line II-II of FIG. 13. FIG. 16 is a cross-sectional view taken along line III-III of FIG. 13.

Referring to FIGS. 12 to 16, in an embodiment, the rotation protrusion member 380 may include a plate body 381 and a protrusion 382. The plate body 381 may be formed in the shape of a plate having a hole formed in a center portion for the shaft 320 to pass through. For example, the plate body 381 may substantially function as a washer plate. The protrusion 382 may protrude in a direction (e.g., the X direction) parallel to the first axis A1 at a position eccentric from the first axis A1. When the shaft 320 rotates about the first axis A1, the protrusion 382 may rotate about the first axis A1 in an arc.

In an embodiment, the sliding member 410 may be slidably positioned in a first direction D1 (e.g., the Y direction) perpendicular to the first axis A1 between the hinge housing 265 and the cover member 700. The sliding member 410 may slide in the first direction D1 (e.g., the Y direction) during the process of folding or unfolding the electronic device 201 by interoperation with the rotation protrusion member 380. A pair of sliding member 410 may be provided. For example, the sliding member 410 may include a first sliding member 410a and a second sliding member 410b. The first sliding member 410a may interoperate with the first rotation protrusion member 380a, and the second sliding member 410b may interoperate with the second rotation protrusion member 380b.

Hereinafter, for convenience of description, the sliding member 410 will be described based on the first sliding member 410a. The second sliding member 410b may be substantially symmetrical to the first sliding member 410a based on a folding axis (e.g., the folding axis A of FIG. 3).

In an embodiment, the sliding member 410 may include a sliding body 411, a first opening 412, and a contact protrusion 413.

In an embodiment, the sliding body 411 may be substantially formed in a plate shape. As shown in FIG. 15, the sliding body 411 may be positioned between a pair of guide protrusions 701 protruding from a rear surface (e.g., a surface in the -Z direction) of the cover member 700. A pair of guide protrusions 701 of the cover member 700 may restrain a sliding path of the sliding body 411 in the first direction D1 (e.g., the Y direction).

In an embodiment, the first opening 412 may be formed in the sliding body 411 to pass through the sliding body 411. The protrusion 382 of the rotation protrusion member 380 may be inserted into the first opening 412. The first opening 412 may have a curved shape having the first axis A1 as a center. For example, the first opening 412 may have an arc shape corresponding to a portion of a path formed when the protrusion 382 rotates about the first axis A1. A length of the arc path formed by the first opening 412 may be shorter than a length of the path along which the protrusion 382 moves until the electronic device 201 is fully folded in a fully unfolded state. For example, a central angle of the arc formed by the first opening 412 may be smaller than an angle at which the protrusion 382 rotates until the electronic device 201 is fully folded in the fully unfolded state. However, the shape of the first opening 412 described above is merely an example, and the shape of the first opening 412 is not limited thereto. In an embodiment, the first opening 412 may be formed in the sliding body 411 in a concave shape without penetrating the sliding body 411. For example, the protrusion 382 of the rotation protrusion member 380 may be inserted into the first opening 412 (or a concave portion) formed in a concave shape.

In an embodiment, the contact protrusion 413 may extend from the sliding body 411. For example, based on the first sliding member 410a, the contact protrusion 413 may extend outward (e.g., the -Y direction) from an outer upper portion (e.g., a portion in the -Y and +Z directions) of the sliding body 411. As shown in FIG. 14, the contact protrusion 413 may be positioned between a pair of guide protrusions 266 protruding from a front surface (e.g., a surface in the +Z direction) of the hinge housing 265. A pair of guide protrusions 266 of the hinge housing 265 may restrain a sliding path of the contact protrusion 413 in the first direction D1 (e.g., the Y direction). According to this structure, the sliding member 410 may be guided to slide in the first direction D1 (e.g., the Y direction) by the cover member 700 (e.g., a pair of guide protrusions 701 of the cover member 700) and the hinge housing 265 (e.g., a pair of guide protrusions 266 of the hinge housing 265).

In an embodiment, as shown in FIG. 16, the sliding member 410 may be positioned inside the hinge housing 265 in the unfolded state of the electronic device 201. In the unfolded state of the electronic device 201, the sliding member 410 may be spaced apart from the first housing 210 or the second housing 220 at a designated distance. For example, in the unfolded state of the electronic device 201, the contact protrusion 413 of the first sliding member 410a and the first housing 210 may be spaced apart by a designated interval. In the process of folding the electronic device 201 from the unfolded state, the sliding member 410 may be slid in the first direction D1 (e.g., the Y direction) by a rotational movement of the protrusion 382.

In an embodiment, the elastic member 420 may be positioned between the sliding member 410 and the hinge housing 265. The elastic member 420 may be configured to restore the position of the sliding member 410 during the process of unfolding the electronic device 201 from the folded state. A pair of elastic members 420 may be provided. For example, the elastic member 420 may include a first elastic member 420a and a second elastic member 420b. The first elastic member 420a may be positioned between an outer end portion (e.g., an end portion in the -Y direction) of the first sliding member 410a and an inner surface of the hinge housing 265. The second elastic member 420b may be positioned between an outer end portion (e.g., an end portion in the +Y direction) of the second sliding member 410b and the inner surface of the hinge housing 265. The first elastic member 420a and the second elastic member 420b may be compressed between the sliding member 410 and the hinge housing 265 to generate an elastic force.

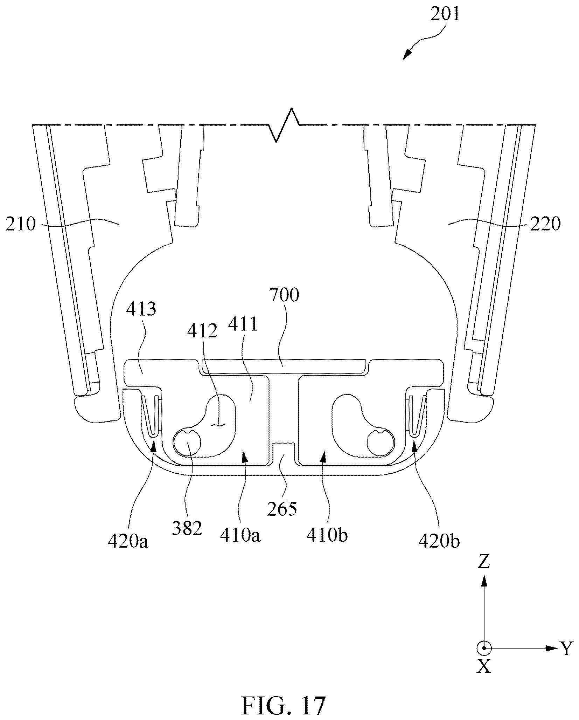

FIG. 17 is a cross-sectional view illustrating a partially folded state of an electronic device according to an embodiment. FIG. 18 is a cross-sectional view illustrating a fully folded state of an electronic device according to an embodiment.

Hereinafter, operations of the rotation protrusion member 380, the sliding member 410, and the elastic member 420 will be described based on the first rotation protrusion member 380a, the first sliding member 410a, and the first elastic member 420a with reference to FIGS. 12 to 18.

In an embodiment, in the fully unfolded state of the electronic device 201 as shown in FIG. 16, the protrusion 382 of the rotation protrusion member 380 may be inserted and positioned at one end portion (e.g., an end portion in the +Y direction and +Z direction) of the first opening 412. In the process in which the state of the electronic device 201 changes from the unfolded state to the folded state, as the first rotation protrusion member 380a rotates about the first axis A1 together with the first shaft 320a, the protrusion 382 may rotate about the first axis A1 in an arc along a path provided by the first opening 412. Since a length of the path formed by the first opening 412 is formed shorter than a length of the path, in which the protrusion 382 moves until the electronic device 201 is fully folded in the fully unfolded state, as shown in FIG. 17, when the electronic device 201 is folded at a designated angle (e.g., 83 degrees to 87 degrees), the protrusion 382 may reach an opposite end portion (e.g., an end portion in the -Y direction and -Z direction) of the first opening 412. When the electronic device 201 is folded at an angle more than the designated angle (e.g., 83 degrees to 87 degrees) in the state shown in FIG. 17, the protrusion 382 may additionally rotate and push the first sliding member 410a in the first direction D1 toward the outside (e.g., the -Y direction). At this time, since the first sliding member 410a is restrained to be able to move only in the first direction D1 by a pair of guide protrusions 266 of the hinge housing 265 and a pair of guide protrusions 701 of the cover member 700, the first sliding member 410a may slide in the first direction D1 toward the outside (e.g., the -Y direction) by an additional rotational movement of the protrusion 382. For example, in the process of folding the electronic device 201 from the unfolded state, the first sliding member 410a may start to slide in the first direction (e.g., the -Y direction) after the electronic device 201 is folded at a designated angle (e.g., 83 degrees to 87 degrees) or more. As shown in FIG. 18, when the electronic device 201 is fully folded, at least a portion of the first sliding member 410a may protrude to the outside of the hinge housing 265 to be in contact with the first housing 210. For example, as the first sliding member 410a slides in the first direction D1 toward the outside (e.g., the -Y direction), the contact protrusion 413 of the first sliding member 410a may be positioned to protrude outward than an end portion of the hinge housing 265, as shown in FIG. 18. As shown in FIG. 18, in the fully folded state of the electronic device 201, the contact protrusion 413 of the first sliding member 410a may be in contact with the first housing 210 (e.g., an inner surface of the first housing 210 in the +Y direction) to push the first housing 210 in the first direction D1 toward the outside (e.g., the -Y direction). During this process, the first elastic member 420a may be compressed. As shown in FIG. 18, in the fully folded state of the electronic device 201, since the first sliding member 410a is in contact with the first housing 210 to push the first housing 210 in the first direction D1 toward the outside (e.g., the -Y direction), a gap G may be maintained between the hinge housing 265 and the first housing 210. This gap G may reduce the phenomenon of the hinge housing 265 and the first housing 210 coming into contact with each other and causing friction during the process of unfolding or folding the electronic device 201. The process of fully unfolding the electronic device 201 from the fully folded state may be understood as the reverse process of the process described above. In the process of fully unfolding the electronic device 201 from the fully folded state, the first sliding member 410a may slide in the first direction D1 toward the inside (e.g., the +Y direction) by an elastic force generated by the first elastic member 420a to return to an original position (e.g., a position of the first sliding member 410a shown in FIG. 16).

In an embodiment, the operations of the second rotation protrusion member 380b, the second sliding member 410b, and the second elastic member 420b may be performed in substantially the same manner as the operations of the first rotation protrusion member 380a, the first sliding member 410a, and the first elastic member 420a. For example, the second sliding member 410b may be positioned inside the hinge housing 265 in the unfolded state of the electronic device 201. In the process in which the state of the electronic device 201 changes from the fully unfolded state to the fully folded state, the second sliding member 410b may slide in the first direction D1 toward the outside (e.g., the +Y direction) by a rotational movement of the protrusion 382 of the second rotation protrusion member 380b about the first axis A1. In the fully folded state of the electronic device 201, at least a portion (e.g., the contact protrusion 413) of the second sliding member 410b may protrude outside the hinge housing 265 to be in contact with the second housing 220 (e.g., an inner surface of the second housing 220 in the -Y direction), and may maintain the gap G between the hinge housing 265 and the second housing 220. In the process of fully unfolding the electronic device 201 from the fully folded state, the second sliding member 410b may slide in the first direction D1 toward the inside (e.g., the -Y direction) by an elastic force generated by the second elastic member 420b to return to an original position (e.g., a position of the second sliding member 410b shown in FIG. 16).

FIG. 19 is a side view illustrating a hinge assembly according to an embodiment.

Referring to FIG. 19, in an embodiment, the elastic member 420 may include the first elastic member 420a, the second elastic member 420b, and a third elastic member 420c. The third elastic member 420c may be positioned between the first sliding member 410a and the second sliding member 410b. In the process of folding an electronic device (e.g., the electronic device 201 of FIG. 2A) from an unfolded state, as the first sliding member 410a and the second sliding member 410b slide away from each other, the third elastic member 420c may be elastically stretched between the first sliding member 410a and the second sliding member 410b. In the process of unfolding an electronic device (e.g., the electronic device 201 of FIG. 2A) from a folded state, the third elastic member 420c may restore the positions of the first sliding member 410a and the second sliding member 410b by generating an elastic force in a direction in which the first sliding member 410a and the second sliding member 410b come closer to each other. Meanwhile, in FIG. 19, the first elastic member 420a, the second elastic member 420b, and the third elastic member 420c are all illustrated, but this is merely an example, and only the third elastic member 420c may be provided. In addition, the shapes of the first elastic member 420a, the second elastic member 420b, and/or the third elastic member 420c shown in the drawings are merely examples, and the first elastic member 420a, the second elastic member 420b, and the third elastic member 420c may be formed of a material having elasticity (e.g., silicone, rubber, and/or sponge).

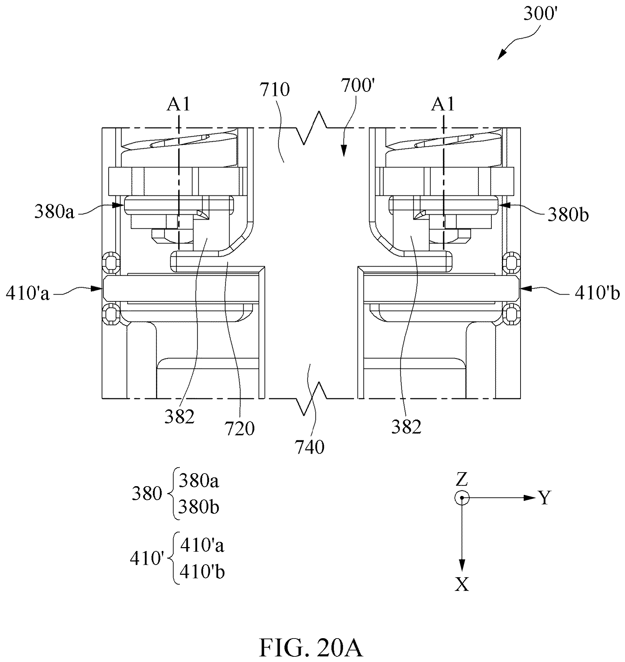

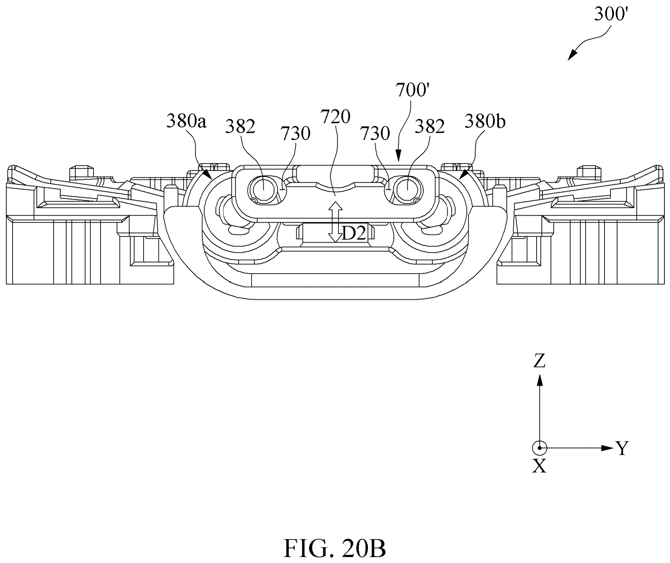

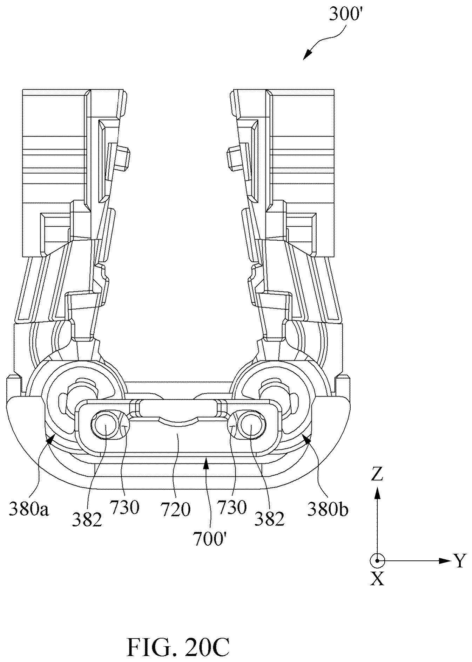

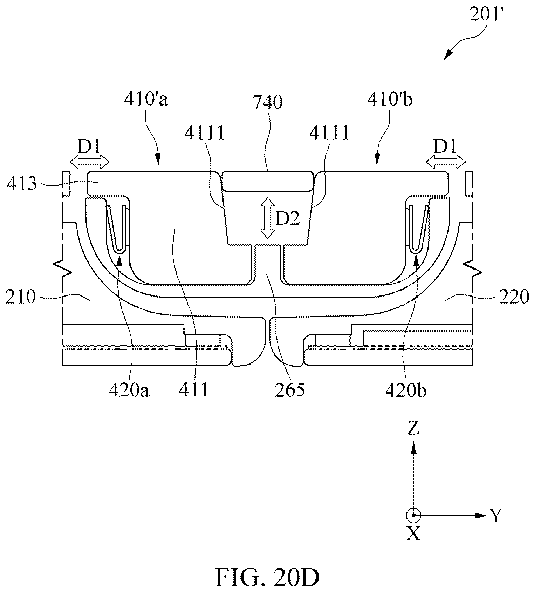

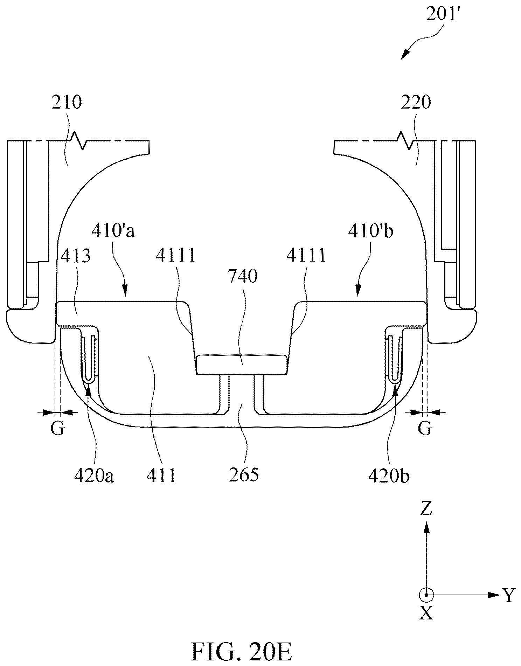

FIG. 20A is a partial front view illustrating a hinge assembly according to an embodiment. FIG. 20B is a side view illustrating an unfolded state of a hinge assembly according to an embodiment. FIG. 20C is a side view illustrating a folded state of a hinge assembly according to an embodiment. FIG. 20D is a cross-sectional view of an unfolded state of an electronic device according to an embodiment. FIG. 20E is a cross-sectional view of a folded state of an electronic device according to an embodiment.

Hereinafter, an electronic device 201' and a hinge assembly 300' according to an embodiment will be described with reference to FIGS. 20A to 20E. In describing the electronic device 201' and the hinge assembly 300' with reference to FIGS. 20A to 20E, specific descriptions of the components that are substantially common to the electronic device 201 and the hinge assembly 300 described with reference to FIGS. 3 to 19 will be omitted and are applied without departing from the scope thereof.

In an embodiment, a cover member 700' may include a main body 710, an expansion body 720, a second opening 730, and an extension body 740.

In an embodiment, the main body 710 may be formed substantially in a plate shape. The main body 710 may be positioned to cover the hinge assembly 300' from the upper side (e.g., the +Z direction). For example, the main body 710 may be positioned between the first rotation protrusion member 380a and the second rotation protrusion member 380b. The expansion body 720 may be formed to expand from the main body 710 to both sides (e.g., the +Y and -Y directions). The expansion body 720 may be formed in a direction perpendicular to the main body 710. For example, the main body 710 may be positioned on an X-Y plane, and the expansion body 720 may be positioned on a Y-Z plane. A pair of second openings 730 may be formed in the expansion body 720. The protrusion 382 of the rotation protrusion member 380 may be inserted into the second opening 730. For example, the second opening 730 may be formed to have a size substantially corresponding to that of the protrusion 382. The extension body 740 may extend from the main body 710 in the longitudinal direction (e.g., an X-axis direction). The extension body 740 may be positioned between the first sliding member 410a and the second sliding member 410b.

In an embodiment, the cover member 700' may slide in a second direction D2 (e.g., a Z direction) perpendicular to the first axis A1 direction (e.g., the X direction) and the first direction (e.g., the Y direction) by a rotational movement about the first axis A1 of the protrusion 382 during the process in which the state of the electronic device 201 changes from the unfolded state to the folded state. For example, when the hinge assembly 300' is folded as shown in FIG. 20C from the unfolded state of the hinge assembly 300' as shown in FIG. 20B, the protrusion 382 of the rotation protrusion member 380 may rotate about the first axis A1 to move substantially downward (e.g., the -Z direction). For example, since the protrusion 382 is inserted into the second opening 730 of the cover member 700', the cover member 700' may also slide downward (e.g., the -Z direction) in response to the downward (e.g., the -Z direction) movement of the protrusion 382. For this, the cover member 700' may be restrained to be slidable in the second direction D2 (e.g., the Z direction) by any other components (e.g., the hinge housing 265).

In an embodiment, a sliding member 410' may include the sliding body 411 and the contact protrusion 413. The sliding body 411 may be formed substantially in a plate shape. One side of the sliding body 411 may be formed as an inclined surface 4111. For example, a first sliding member 410'a and a second sliding member 410'b may have inclined surfaces 4111 in directions facing each other. The inclined surfaces 4111 of the first sliding member 410'a and the second sliding member 410'b may be inclined in a direction in which the inclined surfaces 4111 are closer to each other as it goes downward (e.g., the -Z direction). The inclined surfaces 4111 may be in contact with a side end of the extension body 740 of the cover member 700'. For example, the inclined surface 4111 of the first sliding member 410'a may be in contact with one side end (e.g., an end portion in the -Y direction) of the extension body 740 of the cover member 700', and the inclined surface 4111 of the second sliding member 410'b may be in contact with the other side end (e.g., an end portion in the +Y direction) of the extension body 740 of the cover member 700'. The sliding member 410' may be restrained to be slidable in the first direction D1 (e.g., the Y direction) by any other components (e.g., a shaft bracket (e.g., the shaft bracket 370 of FIG. 5)).

In an embodiment, as shown in FIG. 20D, in the unfolded state of the electronic device 201', the extension body 740 of the cover member 700' may be in contact with an upper end portion (e.g., an end portion in the +Z direction) of the inclined surface 4111 of the sliding member 410'. In the process in which the state of the electronic device 201' changes from the unfolded state to the folded state, when the cover member 700' slides in the second direction D2 (e.g., the Z direction), the sliding member 410 may slide in the first direction D1 (e.g., the Y direction) by contact between a side end of the cover member 700' and the inclined surface 4111 of the sliding member 410'. For example, when the cover member 700' slides in the second direction D2 toward the downward side (e.g., the -Z direction), the first sliding member 410'a may slide in the first direction D1 toward the outside (e.g., the -Y direction) by contact between the side end of the cover member 700' and the inclined surface 4111 of the first sliding member 410'a. As shown in FIG. 20E, in the fully folded state of the electronic device 201', at least a portion of the first sliding member 410'a may protrude outside the hinge housing 265 to be in contact with the first housing 210. For example, as the first sliding member 410'a slides in the first direction D1 toward the outside (e.g., the -Y direction), the contact protrusion 413 of the first sliding member 410'a may be positioned to protrude outward than the end portion of the hinge housing 265, as shown in FIG. 20E. As shown in FIG. 20E, in the fully folded state of the electronic device 201', the contact protrusion 413 of the first sliding member 410'a may come into contact with the first housing 210 (e.g., an inner surface of the first housing 210 in the +Y direction) to push the first housing 210 in the first direction D1 toward the outside (e.g., the -Y direction). During this process, the first elastic member 420a may be compressed. As shown in FIG. 20E, in the fully folded state of the electronic device 201', since the first sliding member 410'a comes into contact with the first housing 210 to push the first housing 210 in the first direction D1 toward the outside (e.g., the -Y direction), the gap G may be maintained between the hinge housing 265 and the first housing 210. This gap G may reduce the phenomenon of the hinge housing 265 and the first housing 210 coming into contact with each other and causing friction during the process of unfolding or folding the electronic device 201'. The process of fully unfolding the electronic device 201' from the fully folded state may be understood as the reverse process of the process described above. In the process of fully unfolding the electronic device 201' from the fully folded state, the first sliding member 410'a may slide in the first direction D1 toward the inside (e.g., the +Y direction) by an elastic force generated by the first elastic member 420a to return to an original position (e.g., a position of the first sliding member 410'a shown in FIG. 20D). The operations of the second rotation protrusion member 380b, the second sliding member 410'b, and the second elastic member 420b may be performed in substantially the same manner as the operations of the first rotation protrusion member 380a, the first sliding member 410'a, and the first elastic member 420a. The second sliding member 410'b may maintain the gap G between the hinge housing 265 and the second housing 220 in the folded state of the electronic device 201' by interoperation between the second rotation protrusion member 380b and the second sliding member 410'b.

In an embodiment, an electronic device 201 may include a display 261 including a first area 261a, a second area 261b, and a folding area 261c between the first area 261a and the second area 261b, a first housing 210 configured to support the first area 261a and including a first seating portion 214, a second housing 220 configured to support the second area 261b and including a second seating portion 224, a hinge housing 265 which is positioned on the first seating portion 214 and the second seating portion 224 in an unfolded state of the electronic device 201, and at least a portion of which is exposed to outside of the electronic device in a folded state of the electronic device 201, and a hinge assembly 300 positioned inside the hinge housing 265 and connecting the first housing 210 and the second housing 220. The hinge assembly 300 may include a hinge bracket 310, a shaft 320 rotatably connected to the hinge bracket 310 about a first axis A1, a rotation protrusion member 380 connected to one end portion of the shaft 320 to rotate integrally with the shaft 320, and including a protrusion 382 protruding parallel to the first axis A1 at a position eccentric from the first axis A1, and a sliding member 410 positioned to be slidable with respect to the hinge housing 265 in a first direction D1 perpendicular to the first axis A1. In the unfolded state of the electronic device 201, the sliding member 410 may be positioned inside the hinge housing 265. In a process in which the state of the electronic device 201 changes from the unfolded state to the folded state, the sliding member 410 may slide in the first direction D1 by a rotational movement of the protrusion 382 about the first axis A1. In the folded state of the electronic device 201, at least a portion of the sliding member 410 may protrude outside the hinge housing 265 to be in contact with the first housing 210 or the second housing 220.

In an embodiment, in a process of folding the electronic device 201 in the unfolded state, the sliding member 410 may begin to slide in the first direction D1 after the electronic device 201 is folded at a designated angle or greater.

In an embodiment, in the folded state of the electronic device 201, the sliding member 410 may maintain a gap between the first hinge housing 265 and the first housing 210 or between the hinge housing 265 and the second housing 220.

In an embodiment, the hinge assembly 300 may further include an elastic member 420 configured to restore a position of the sliding member 410 in a process of unfolding the electronic device 201 in the folded state.

In an embodiment, the elastic member 420 may be positioned between the sliding member 410 and the hinge housing 265.

In an embodiment, the sliding member 410 may include a first opening 412, into which the protrusion 382 is inserted.

In an embodiment, the first opening 412 may have a curved shape having the first axis A1 as a center.

In an embodiment, a length of a path formed by the first opening 412 may be shorter than a length of a path, along which the protrusion 382 moves until the electronic device 201 is folded in the unfolded state.

In an embodiment, the hinge assembly 300 may further include a cover member 700, 700' covering the hinge assembly 300.

In an embodiment, the sliding member 410 may be guided to slide in the first direction D1 by the cover member 700 and the hinge housing 265.

In an embodiment, the cover member 700' may include a second opening 730, into which the protrusion 382 is inserted.

In an embodiment, the cover member 700' may slide in a second direction D2 perpendicular to the first axis A1 and the first direction D1 by the rotational movement of the protrusion 382 about the first axis A1 in the process in which the state of the electronic device 201 changes from the unfolded state to the folded state.

In an embodiment, the sliding member 410' may include an inclined surface 4111 which is in contact with a side end of the cover member 700'.

In an embodiment, in the process in which the state of the electronic device 201 changes from the unfolded state to the folded state, when the cover member 700' slides in the second direction D2, the sliding member 410' may slide in the first direction D1 by contact between the side end of the cover member 700' and the inclined surface 4111 of the sliding member 410'.

In an embodiment, a pair of the shafts 320, a pair of the rotation protrusion members 380, and a pair of the sliding members 410 may be provided.

In an embodiment, a hinge assembly 300 applied to an electronic device 201 including a first housing 210, a second housing 220, and a hinge housing 265 may include a hinge bracket 310, a shaft 320 rotatably connected to the hinge bracket 310 about a first axis A1, a rotation protrusion member 380 connected to one end portion of the shaft 320 to rotate integrally with the shaft 320, and including a protrusion 382 protruding parallel to the first axis A1 at a position eccentric from the first axis A1, and a sliding member 410 positioned to be slidable with respect to the hinge housing 265 in a first direction D1 perpendicular to the first axis A1. In the unfolded state of the electronic device 201, the sliding member 410 may be positioned inside the hinge housing 265. In a process in which the state of the electronic device 201 changes from the unfolded state to the folded state, the sliding member 410 may slide in the first direction D1 by a rotational movement of the protrusion 382 about the first axis A1. In the folded state of the electronic device 201, at least a portion of the sliding member 410 may protrude outside the hinge housing 265 to be in contact with the first housing 210 or the second housing 220.

In an embodiment, in a process of folding the electronic device 201 in the unfolded state, the sliding member 410 may begin to slide in the first direction D1 after the electronic device 201 is folded at a designated angle or greater.

In an embodiment, the sliding member 410 may include a first opening 412, into which the protrusion 382 is inserted. The first opening 412 may have a curved shape having the first axis A1 as a center.

In an embodiment, the hinge assembly 300 may further include a cover member 700' configured to cover the hinge assembly 300 and including a second opening 730, into which the protrusion 382 is inserted. The sliding member 410' may include an inclined surface 4111 which is in contact with a side end of the cover member 700'.

In an embodiment, an electronic device 201 may include a display 261 including a first area 261a, a second area 261b, and a folding area 261c between the first area 261a and the second area 261b, a first housing 210 configured to support the first area 261a and including a first seating portion 214, a second housing 220 configured to support the second area 261b and including a second seating portion 224, a hinge housing 265 which is positioned on the first seating portion 214 and the second seating portion 224 in an unfolded state of the electronic device 201, and at least a portion of which is exposed to outside of the electronic device 201 in a folded state of the electronic device 201, and a hinge assembly 300 positioned inside the hinge housing 265 and connecting the first housing 210 and the second housing 220. The hinge assembly 300 may include a hinge bracket 310, a shaft 320 rotatably connected to the hinge bracket 310 about a first axis A1, a rotation protrusion member 380 connected to one end portion of the shaft 320 to rotate integrally with the shaft 320, and including a protrusion 382 protruding parallel to the first axis A1 at a position eccentric from the first axis A1, a sliding member 410 positioned to be slidable with respect to the hinge housing 265 in a first direction D1 perpendicular to the first axis A1 and including a first opening 412, into which the protrusion 382 is inserted, an elastic member 420 configured to restore a position of the sliding member 410 in a process of unfolding the electronic device 201 in the folded state, and a cover member 700 covering the hinge assembly 300. In the unfolded state of the electronic device 201, the sliding member 410 may be positioned inside the hinge housing 265. In the folded state of the electronic device 201, the sliding member 410 may slide in the first direction D1. In the folded state of the electronic device 201, at least a portion of the sliding member 410 may protrude outside the hinge housing 265 to be in contact with the first housing 210 or the second housing 220. The first opening 412 may have a curved shape having the first axis A1 as a center. A length of a path formed by the first opening 412 may be shorter than a length of a path, along which the protrusion 382 moves until the electronic device 201 is folded in the unfolded state. The sliding member 410 may be guided to slide in the first direction D1 by the cover member 700 and the hinge housing 265.

## Claims

1. An electronic device (201) comprising:
a display (261) comprising a first area (261a), a second area (261b), and a folding area (261c) between the first area (261a) and the second area (261b);
a first housing (210) configured to support the first area (261a) and comprising a first seating portion (214);
a second housing (220) configured to support the second area (261b) and comprising a second seating portion (224);
a hinge housing (265) which is positioned on the first seating portion (214) and the second seating portion (224) in an unfolded state of the electronic device (201), and at least a portion of which is exposed to outside of the electronic device (201) in a folded state of the electronic device (201); and
a hinge assembly (300) positioned inside the hinge housing (265) and connecting the first housing (210) and the second housing (220),
wherein the hinge assembly (300) comprises:
a hinge bracket (310);
a shaft (320) rotatably connected to the hinge bracket (310) about a first axis (A1);
a rotation protrusion member (380) connected to one end portion of the shaft (320) to rotate integrally with the shaft (320), and comprising a protrusion (382) protruding parallel to the first axis (A1) at a position eccentric from the first axis (A1); and
a sliding member (410) positioned to be slidable with respect to the hinge housing (265) in a first direction (D1) perpendicular to the first axis (A1), and
wherein, in the unfolded state of the electronic device (201), the sliding member (410) is positioned inside the hinge housing (265), in a process in which the state of the electronic device (201) changes from the unfolded state to the folded state, the sliding member (410) slides in the first direction (D1) by a rotational movement of the protrusion (382) about the first axis (A1), and in the folded state of the electronic device (201), at least a portion of the sliding member (410) protrudes outside the hinge housing (265) to be in contact with the first housing (210) or the second housing (220).

2. The electronic device (201) of claim 1, wherein, in a process of folding the electronic device (201) in the unfolded state, the sliding member (410) begins to slide in the first direction (D1) after the electronic device (201) is folded at a designated angle or greater.

3. The electronic device (201) of claim 1 or 2, wherein, in the folded state of the electronic device (201), the sliding member (410) maintains a gap between the first hinge housing (265) and the first housing (210) or between the hinge housing (265) and the second housing (220).

4. The electronic device (201) of any one of claims 1 to 3, wherein the hinge assembly (300) further comprises an elastic member (420) configured to restore the position of the sliding member (410) in a process of unfolding the electronic device (201) in the folded state.

5. The electronic device (201) of any one of claims 1 to 4, wherein the elastic member (420) is positioned between the sliding member (410) and the hinge housing (265).

6. The electronic device (201) of any one of claims 1 to 5, wherein the sliding member (410) comprises a first opening (412), into which the protrusion (382) is inserted.

7. The electronic device (201) of any one of claims 1 to 6, wherein the first opening (412) has a curved shape having the first axis (A1) as a center.

8. The electronic device (201) of any one of claims 1 to 7, wherein a length of a path formed by the first opening (412) is shorter than a length of a path, along which the protrusion (382) moves until the electronic device (201) is folded in the unfolded state.

9. The electronic device (201) of any one of claims 1 to 8, wherein the hinge assembly (300) further comprises a cover member (700; 700') covering the hinge assembly (300).

10. The electronic device (201) of any one of claims 1 to 9, wherein the sliding member (410) is guided to slide in the first direction (D1) by the cover member (700) and the hinge housing (265).

11. The electronic device (201) of any one of claims 1 to 10, wherein the cover member (700') comprises a second opening (730), into which the protrusion (382) is inserted.

12. The electronic device (201) of any one of claims 1 to 11, wherein the cover member (700') slides in a second direction (D2) perpendicular to the first axis (A1) and the first direction (D1) by the rotational movement of the protrusion (382) about the first axis (A1) in the process in which a state of the electronic device (201) changes from the unfolded state to the folded state.

13. The electronic device (201) of any one of claims 1 to 12, wherein the sliding member (410') comprises an inclined surface (4111) which is in contact with a side end of the cover member (700').

14. The electronic device (201) of any one of claims 1 to 13, wherein, in the process in which the state of the electronic device (201) changes from the unfolded state to the folded state, when the cover member (700') slides in the second direction (D2), the sliding member (410') slides in the first direction (D1) by contact between the side end of the cover member (700') and the inclined surface (4111) of the sliding member (410').

15. The electronic device (201) of any one of claims 1 to 14, wherein a pair of the shafts (320), a pair of the rotation protrusion members (380), and a pair of the sliding members (410) are provided.
